(19) Europäisches Patentamt
European Patent Office
Office européen des brevets

(11) **EP 1 854 113 B1**

(12) **EUROPEAN PATENT SPECIFICATION**

(45) Date of publication and mention of the grant of the patent:
**17.05.2017 Bulletin 2017/20**

(21) Application number: **05792288.2**

(22) Date of filing: **11.10.2005**

(51) Int Cl.:
*H01H 9/56* (2006.01)     *G01R 19/00* (2006.01)

(86) International application number:
**PCT/SE2005/001508**

(87) International publication number:
**WO 2006/043871 (27.04.2006 Gazette 2006/17)**

(54) **AN APPARATUS AND A METHOD FOR PREDICTING A FAULT CURRENT**

VORRICHTUNG UND VERFAHREN ZUR VORHERSAGE EINES FEHLERSTROMS

APPAREIL ET PROCEDE PERMETTANT DE PREDIRE UN COURANT DE DEFAUT

(84) Designated Contracting States:
**AT BE BG CH CY CZ DE DK EE ES FI FR GB GR HU IE IS IT LI LT LU LV MC NL PL PT RO SE SI SK TR**

(30) Priority: **22.10.2004 SE 0402590**

(43) Date of publication of application:
**14.11.2007 Bulletin 2007/46**

(73) Proprietor: **ABB Schweiz AG**
**5400 Baden (CH)**

(72) Inventor: **THOMAS, Richard**
**S-771 42 Ludvika (SE)**

(74) Representative: **Axell, Kristina et al**
**ABB AB**
**Intellectual Property**
**Forskargränd 7**
**721 78 Västerås (SE)**

(56) References cited:
EP-A1- 1 006 538          DE-A1- 2 932 929
US-A- 5 216 621          US-A- 5 793 594
US-A1- 2004 090 719      US-B1- 6 597 999

• **POLTL A. ET AL: 'A New Algorithm Enabling Controlled Short Circuit Interruption' IEEE TRANSACTIONS ON POWER DELIVERY vol. 18, no. 3, July 2003, pages 802 - 808, XP002993857**

## Description

FIELD OF THE INVENTION AND PRIOR ART

The present invention relates to an apparatus for predicting future behavior of an asymmetric fault current in a current path, as well as a method for such prediction.

A fault current is a current transient caused for example by a short circuit in the current path. When such a fault current occurs a current interruption device has to open the current path, i.e. to break the current, as soon as possible to prevent damaging different types of equipment connected to the current path.

High voltage alternating current interruption devices work on the basis of interrupting at natural current zero crossings after contact opening. An ideal interruption device would be able to open its contacts precisely at a current zero crossing and achieve interruption. Existing high voltage alternating current circuit interruption devices utilize an arc formed between their opening contacts, such than when the arc extinguishes at current zero, the circuit is physically broken by virtue of the contact gap. Such devices are called arc based interruption devices. In reality the high thermal stress of a fault current arc, combined with the dielectric stress imposed across the open contacts of the interruption device after current interruption, requires that the interruption device contacts achieve a minimum contact gap prior to the current zero crossing in order to ensure a successful interruption. This corresponds to a minimum arcing time required prior to successful interruption at a current zero crossing. The minimum arcing time is the shortest arcing time for which the interruption device can successfully interrupt the current for a given combination of current, voltage and frequency.

There is a limit for acceptable arcing wear in an arc based interrupting device, beyond which the interruption performance of the interrupter according to its rated performance values can no longer be assured. At this limit the worn interrupter parts must be replaced. The larger the current being interrupted and longer the arcing time, the more wear occurs on the interrupter arcing contacts and nozzle due to larger net radiated arc energy. Thus, if the arcing time can be restricted, the interrupter wear can also be reduced and the circuit breaker can be used for longer periods between intrusive interrupter maintenance. Having an arcing time longer than the minimum arcing time adds to the electrical wear of the interrupters without adding any contribution to the eventual interruption of the current.

Accordingly, there is a desire to be able to predict the behaviour of fault currents in power systems with a high degree of accuracy in order to achieve an optimized control of the current interruption devices. More specifically, it is a desired to predict the current zero crossings of the fault current in the individual case so as to be able to achieve interruption with an optimal arcing time. The current zero to be targetted to achieve optimal arcing time is not always the first possible current zero after the circuit breaker contacts start to open. The optimal arcing time must take account of the minimum arcing time that the breaker can manage for the given combined voltage, current and frequency stresses. If the time between breaker contacts parting and a current zero is less than the minimum arcing time the breaker will not interrupt at that current zero, but continue to conduct current through the arc until at least the next following current zero.

In addition to arc based interruption devices, there exist other devices for current interruption, for example diode or thyristor based devices that interrupt without arc formation inside the device. Such devices will still interrupt at current zero crossings. However, such devices can be limited in the amount of time they can conduct current, and as such it can be desirable to implement such devices with a control scheme that synchronizes when they are active in the circuit, commonly referred to as commutation, i.e. switching current flow from one current path to another current path. Such a control scheme would therefore need to predict current behaviour, in particular future current zero crossing times.

Applying controlled, synchronized fault current interruption presents a more difficult problem than for stable, steady state power system load cases e.g. capacitor banks, reactors. The main source of difficulty arises from the transient nature of fault currents, which often results in an asymmetrical behaviour of the fault current. Thus, the lack of periodicity of the fault current makes it difficult to determine future current zero crossings.

In an article with the title "A new algorithm enabling controlled short circuit interruption", published in "IEEE Transactions on power delivery" Vol. 18, No 3, July 2003, by Anton Pöltl and Klaus Fröhlich, a method for predicting the fault current is proposed. They have proposed a scheme, referred to as safepoint, for determining a viable target on the current waveform to which an interrupter's contact opening could be synchronized under fault conditions. The safepoint method proposes a scheme whereby the synchronization target is not directly based on a future current zero crossing, but rather on a chosen periodically occurring instant on the fault current, known to always precede a current zero crossing. This approach is motivated by the perceived difficulty in being able to accurately predict future current zero behavior in a fault current within a reasonable data processing time (5-6ms), corresponding to very high speed transmission protection scheme operating times of approximately 1/4 of a power system cycle.

A weakness of the proposed algorithm is the time difference between safepoints and natural current zero crossings, which leads to a less than optimal solution in terms of minimizing arcing time. The proposed method also requires a very high sampling frequency, about 10 kHz, and thus an expensive measuring equipment is needed.

In the international patent application WO-01/95354 a method and an apparatus for predicting a current zero crossing of an alternating current after occurrence of a fault current in a current path has been proposed for the purpose of determining the suitable time for opening an interruption device arranged in the current path. The method includes that the current in the current path is detected, that the dc-level of the current and the decay over time of the dc-level are calculated on the basis of the values of the alternating current detected, and that the time for a future current zero-crossing of the alternating current is predicted on the basis of the current values obtained through said current detection, the calculated dc-level, the calculated dc-decay and the period time of the alternating current. This method requires measurements over an entire time period of the fault current to be able to predict a future current zero crossing. For the purpose to control the interruption of the fault current the time period for determining the future current zero crossings should be as short as possible, and to have to wait a whole time period is too long for achieving an optimized control of the interruption device.

US6,597,999 discloses a method for predicting zero crossings of fault currents. The method includes sensing a fault current, estimating parameters of a model of the fault current, and using the estimated parameters to predict the zero crossings. The presence of a fault is detected by comparing sampled current values with a threshold value. A fault is detected when the sampled values is above the threshold value. The zero crossings are predicted by selecting an initial time interval in which the first zero crossing is present, identifying a portion of the interval that includes the zero crossing and using a bisection method to reduce the window around the zero crossing until the reduced window provides the desired resolution.

OBJECTS AND SUMMARY OF THE INVENTION

The object of the present invention is to provide an improved prediction of future behavior of an asymmetric fault current in a current path, which alleviates the problems mentioned above, and enables a fast and accurate prediction of future current zero crossings.

According to one aspect of the invention this object is achieved by the method according to claim 1.

According to another aspect of the invention this object is achieved by the apparatus according to claim 16.

According to a further aspect of the invention, the object is achieved by a computer program directly loadable into the internal memory of a computer or a processor, comprising software code portions for performing the steps of the method according to the invention, when said program is run on a computer. The computer program is provided either on a computer readable medium or through a network

According to another aspect of the invention, the object is achieved by a computer readable medium having a program recorded thereon, when the program is to make a computer perform the steps of the method according to the invention, and said program is run on the computer.

According to the invention sampled values of the current are saved in a moving sampling window, future values of the current are continuously predicted and sampled values of the current from the same point in time are compared with the predicted values of the current, and on basis thereof it is continuously determined whether or not a fault current has occurred in the current path. When a fault current has been detected the sampling window is adjusted to discard current values prior to the fault current. Thereafter, future values of the fault current are predicted based on the current values in the adjusted sampling window. The invention teaches the use of an adaptively sized sampling window. The algorithm is continuously self-checking thus reduces the risk that an incorrect targetting might occur during interruption control. Thanks to the fast detection of the occurrence of a fault current in the current path, and the fact that current values prior to the fault current are rejected upon detecting that a fault current has occurred, the prediction of the fault current at its beginning is improved. Thus, the time period until an accurate prediction of the fault current has been accomplished is considerably reduced compared to the prior art methods. Such a short time period makes it possible to improve the optimization of the control of the interruption of the fault current.

According to an embodiment of the invention the prediction of the fault current comprises estimating one or more characteristic parameters for the current, including the voltage phase angle at the point in time when the fault current started, based on the data in the sampling window, and predicting future values of the fault current based on said estimated characteristic parameters. The estimated characteristic parameters, besides the voltage phase angle, are for example the time constant of fault current, the value of the current at fault initiation, and the magnitude of the fault current. The angular power frequency is determined separately by measurement of the voltage waveform one cycle time period. The prediction of the current at switching on of the system is based on an assumed or known synchronized value of the voltage phase angle and the prediction of the fault current is based on the estimated fault initiation voltage phase angle. This embodiment of the invention takes account that the pre-fault current at the time the fault starts has an impact on the prediction of the fault current.

According to this embodiment the current is predicted by means of a mathematical model considering the impact of the voltage phase angle on the current, thus obtaining an improved prediction of the current. A further advantage with this embodiment is the accuracy and sensitivity of the prediction of the fault current. Another advantage gained by using a mathematical model, considering the voltage phase angle, is that the time to accomplish a satisfying prediction is further reduced. The improved mathematical model used also reduces the sample frequency needed. With a method according to this embodiment of the invention it is possible to achieve an acceptable prediction with a sampling frequency of 1kHz. Preferably, a sampling frequency of in the range of 2 kHz to 4 kHz should be used.

According to an embodiment of the invention the method comprises continuously samples the voltage in the current path and saves sampled values of the voltage in a second moving sampling window, and when a fault current has been detected, determining the point in time when the fault current started, estimating the voltage phase angle at the point in time when the fault current started based on said sampled values of the voltage, and predicting said future values of the current based on said estimated voltage phase angle.

According to an embodiment of the invention a fault current is detected by deciding whether the predicted current is sufficiently accurate based on said comparison of the predicted and sampled current values, and if the predicted current is not sufficiently accurate determining whether there is a lasting negative trend in the accuracy of the prediction and on basis thereof decide if a fault current has occurred. Preferably, it is determined whether the difference between the predicted and measured current values increases over a predetermined number of sequential samples, and if so a fault current is detected.

According to an embodiment of the invention the method comprises determining the point in time when the fault current started by determining the point in time when the negative trend started, and estimating the voltage phase angle at the point in time when the negative trend started.

According to an embodiment of the invention the method comprises estimating one or more future zero crossings of the fault current based on the predicted future values of the current, and based on the estimated zero crossings controlling the action of an interruption device arranged in the current path for interrupting the current upon command, in order to optimize the current interruption. By this embodiment it is possible to estimate the zero crossings of a fault current within a short time period after the fault current has occurred.

According to an embodiment of the invention the interruption device is an arc based interruption device adapted to open upon command, and the method comprises synchronizing the opening of the interruption device with respect to the estimated future zero crossings of the current in order to achieve a desired arcing time. Thanks to the fast and accurate prediction of the current zero crossings, it is possible to synchronize the opening of the interruption device with respect to the earliest viable, predicted current zero in order to restrict the arcing time and thereby reduce the electrical stress and wear on the interrupter.

According to an embodiment of the invention said interruption device has a certain opening time, and said synchronizing includes delaying the opening command to the interruption device with respect to the sum of the opening time of the interruption device and a desired arcing time. Once a suitable future current zero has been found, the opening command to the interrupting device is synchronized such that the interrupting device will open its arching contacts at a time prior to the current zero, this time corresponding to a preselected optimum arcing time. The optimum arcing time is chosen such that interruption is assured with an acceptable probability. For example, it is advantageous to select the desired arcing time as the minimum arcing time plus a safety margin. Thereby, the electrical stress on the interruption device is reduced compared to that may have occurred with an uncontrolled opening of the device. Also the electrical wear on the interruption device is reduced.

According to an embodiment of the invention the method comprises repeatly calculating a new time period for the delay of the opening command, based on the difference between a selected estimated current zero crossing and the sum of the desired arcing time and the opening time of the interruption device. If more than one zero crossing is predicted, one of them is selected. Preferably, a new time period is calculated each time sample. Thanks to the fact that a new delay time is repeatly calculated during the delay of the opening command, the calculation of delay time is improved, as the estimation of the zero crossing is improved over time.

According to an embodiment of the invention the method comprises continuously comparing the values of the current with sampled values of the current from the same point in time, and on basis thereof deciding whether the predicted current is sufficiently accurate or not, and if the predicted current is not sufficiently accurate the time period for the delay of the opening command is set to zero. If the difference between a predicted and a measured value from the same point in time is lower than a predetermined limit value, the prediction is taken as acceptable, but if the difference is above the limit value the prediction is not acceptable and the delay time for the opening command is set to zero. Thus, unduly inhibiting of the opening command is avoided.

According to an embodiment of the invention the method comprises calculating a time constant for the fault current based on the sampled values of the current, calculating the magnitude of the fault current for at least the two earliest estimated current zero crossings viable for interruption, calculating an arc current integral for each of said two earliest estimated current zero crossings, based on the mathematical model of the current, the calculated time constant and the calculated magnitude of the fault current, wherein the upper time boundary is the estimated current zero crossing and the lower time boundary is the upper time boundary minus the desired arcing time, comparing the calculated arc current integrals, and calculating the time period for the delay of the opening command based the current zero crossing corresponding to the lowest of the calculated arc current integrals. The calculated integrals correspond to the arcing time. Thus, the opening of the interruption device is controlled so that a minimum arcing integral is achieved.

According to an embodiment of the invention the method comprises estimating the fault current exponential component time constant by means of a truncated Taylor series approximations of the exponential component, and predicting future values of the fault current based on said estimated time constant.

According to an embodiment of the invention the method comprises estimating the fault current exponential component time constant by means of a truncated Taylor series approximations of the exponential component, and predicting future values of the fault current based on said estimated time constant. The proposed method is designed to use a Taylor series approximations of the exponential component, i.e. $e(-x) = 1-x$ or $1 - x + x^2/2$, which provides a more accurate estimation of the fault current's exponential component time constant $\tau$ than the prior art methods.

The main benefits of the proposed method and apparatus are summarized below:

Prediction of future current zero times facilitates a more optimal controlled fault interruption, in the following called CFI, result as it permits use of minimum arcing time with a nominal safety margin, as opposed to using a target that is prior to the current zero time(s). The margin between the target arcing time and the minimum arcing time can be minimized.

The method provides a full model prediction of the future fault current behavior, including the current magnitude and thus facilitates possible calculation of the future arcing time current integral. This information could then be used for further optimization of the interruption process, for example enabling implementation of arc energy optimized CFI.

The built in FO-test provides self-regulation of the algorithm, not only facilitating data window size adjustment, but also enabling overall control co-ordination with external protection systems so that in the event of failure of the algorithm to arrive at a viable current model estimation, the CFI scheme can be disabled and protection not unnecessarily inhibited.

It is possible to implement fault initiation directly within the algorithm, using FO trend analysis, with minimal added processing burden.

The algorithm retains the benefits of the safepoint approach in respect of the possibility to pre-process the more computationally onerous matrix components and reduce the real time calculation burden.

The use of the Taylor series approximation of the exponential term in the fault current model facilitates least means square regression, offers potentially better results for lower time constant values and is flexible in application with respect to number of terms applied.

The invention is useful in connection with a current path in a high voltage alternating current power system having a nominal operating frequencies ranging from 15 to 60Hz, and a voltage between 1-800kV. For example, the invention is useful in connection with current paths for electricity supply within industry, a. c. railway systems or in distribution or transmission networks.

The invention is particularly useful for determining future current crossings for the purpose of controlling the arcing time of an arc based interruption device.

The invention is also particularly useful for determining future current crossings for the purpose of controlling the commutation time of an interruption device.

BRIEF DESCRIPTION OF THE DRAWINGS

The invention will now be explained more closely by the description of different embodiments of the invention and with reference to the appended figures.

Fig. 1    illustrates general principals for controlled fault interruption.

Fig. 2    shows a block diagram over an apparatus for fault interruption of a current path according to an embodiment of the invention.

Fig. 3    illustrates in general terms a method for controlling the interruption of an interruption device according to an embodiment of the invention.

Fig. 4    illustrates in more details a method for controlling the interruption of an interruption device according to an embodiment of the invention.

Fig. 5    illustrates an adjustable data window.

Fig. 6    illustrates a current zero search.

Fig. 7    shows FO trend analysis used for fault detection and initial phase angel estimation.

Fig. 8    shows a fault current in a current path and parameters in relation to the invention.

DETAILED DESCRIPTION OF PREFERRED EMBODIMENTS OF THE INVENTION

In the following, by way of an example, the invention will be described in connection with an arc-based circuit breaker. The circuit breaker is connected in a current path so as to be able to rapidly open or close this and by that break and establish, respectively, the current in the current path. The primary goal of controlled fault interruption, in the following denoted CFI, is to synchronize the opening instant of arcing contacts of a circuit breaker with respect to a target current zero crossing, in the following denoted a current zero, subject to the constraint of a minimum viable arcing time prior to the target current zero. The circuit breaker is also controlled by a protection system adapted to determine whether or not the circuit breaker should be tripped and to send an order to the circuit breaker to open.

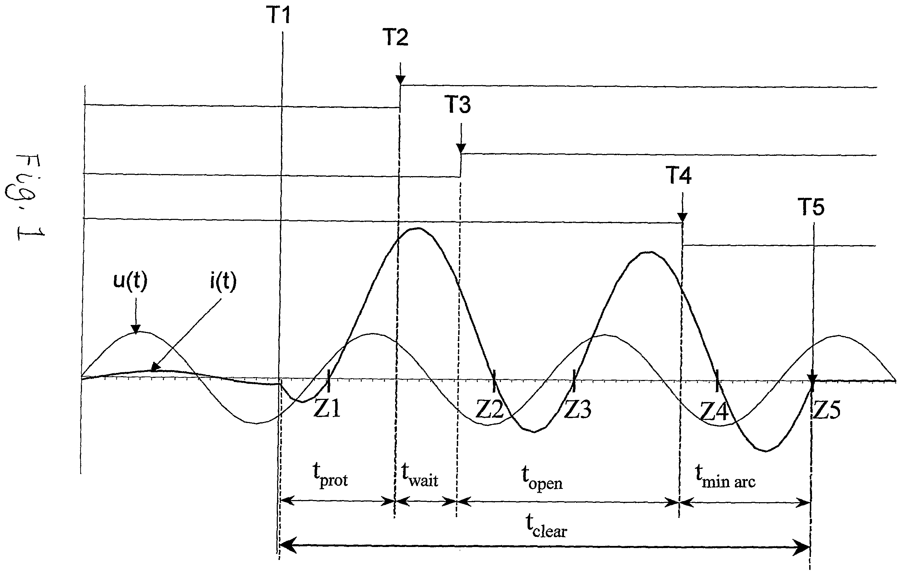

The fundamental operating principle for CFI is illustrated in figure 1. The figure illustrates the source voltage u(t) and the current i(t) before and after the point in time 1 when a fault has been initiated in a current path. As seen from the figure the fault current, i.e. the current in the current path after the fault has occurred, is asymmetric and has decreasing asymmetry. At a point in time T1 a fault current occurred. The protection system recognizes the fault at a time T2. The time period between T1 and T2 is denoted the protection response time $t_{prot}$. The protection system issues an opening signal at time T3. The time period between T2 and T3 is denoted the wait time $t_{wait}$. The time it takes from the protection system issued the opening command, until the breaker contacts starts to move away from each other from the is denoted the circuit breaker opening time $t_{open}$. The contact parting begins at T4. A minimum arcing time $T_{min-arc}$ corresponds to the minimum time required prior to successful interruption at a current zero crossing. The fault current in this example has five current zero crossings Z1 - Z5. At time T5 the current is interrupted at the current zero crossing Z5. The total time limit from the fault initiation to the current interrupting is the total clearing time $T_{clear}$ and lasts through about 2-3 cycles.

The ideal target for CFI is the earliest, viable current zero, occurring after fault initiation allowing for a given operating time of the protection system, the circuit breaker opening time and the minimum arcing time. Once the target has been identified and it has been determined that the breaker should be tripped, it is then a case of timing i.e. "synchronizing", the opeining command to the circuit breaker in relation to its opening time such that the minimum arcing time is achieved. The CFI can be implemented almost entirely as a software addition to a conventional protection system - circuit breaker installation. The CFI algorithm ideally could utilize the same measurement sources as associated protection system, even to the extent of utilizing the same signal processing system as the protection system, assuming they are of a digital numerical type. Thus, the method and apparatus according to the invention can be implemented as a software addition to a conventional protection system.

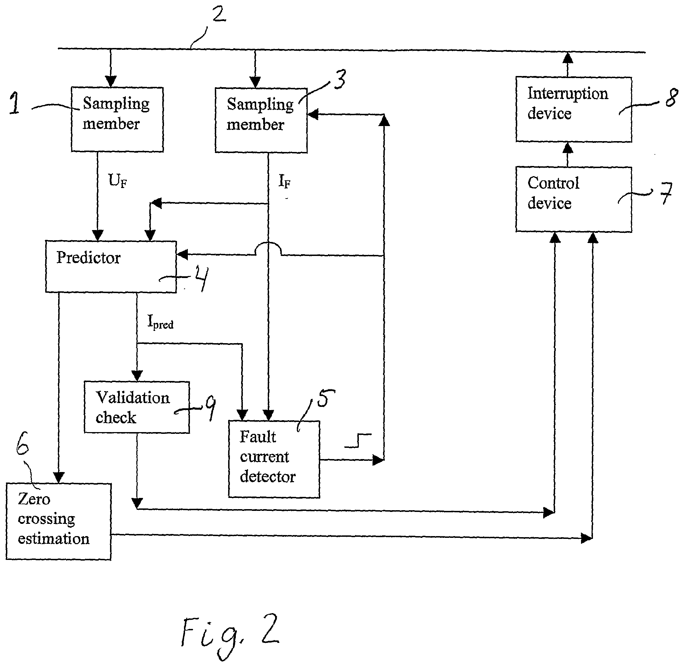

Figure 2 shows a block diagram over an apparatus for fault interruption of a current path according to an embodiment of the invention. 17. The apparatus comprises a first sampling member 1 adapted to continuously sample the current in a current path 2 and to save sampled values of the current in a moving sampling window, a second sampling member 3 adapted to continuously sample the voltage in the current path and to save sampled values of the voltage in a second moving sampling window, a predictor arrangement 4 adapted to predict future values of the current in the current path based on the sampled current values and a mathematical model of the current, a fault current detector 5 adapted to compare the predicted current values with sampled current values from the same point in time, and on basis thereof determined whether or not a fault current has occurred in the current path, and the first sampling member 1 is adapted to, upon detecting a fault current, adjust the sampling window to discard current values prior to the fault current, and that said predictor arrangement is adapted to predict future values of the fault current based on the current values in the adjusted sampling window.

The apparatus further comprises a zero crossing estimator 6 adapted to estimate future zero crossings of the fault current based on the predicted future values of the current, and a control device 7 adapted to control the action of an interruption device 8, arranged in the current path and adapted to upon command interrupt the current in the current path, based on the estimated current zero crossings in order to optimize the current interruption. The apparatus further comprises a validation check module 9 adapted to continuously decide whether the predicted current is sufficiently accurate or not based on a comparison of predicted and sampled values of the current from the same point in time, and if the predicted current is not sufficiently accurate the waiting time of the opening command is set to zero. It should be noted that the set of the waiting time to zero is not he end of the algorithm, in the opposite the current prediction and calculation of the waiting time are continuing.

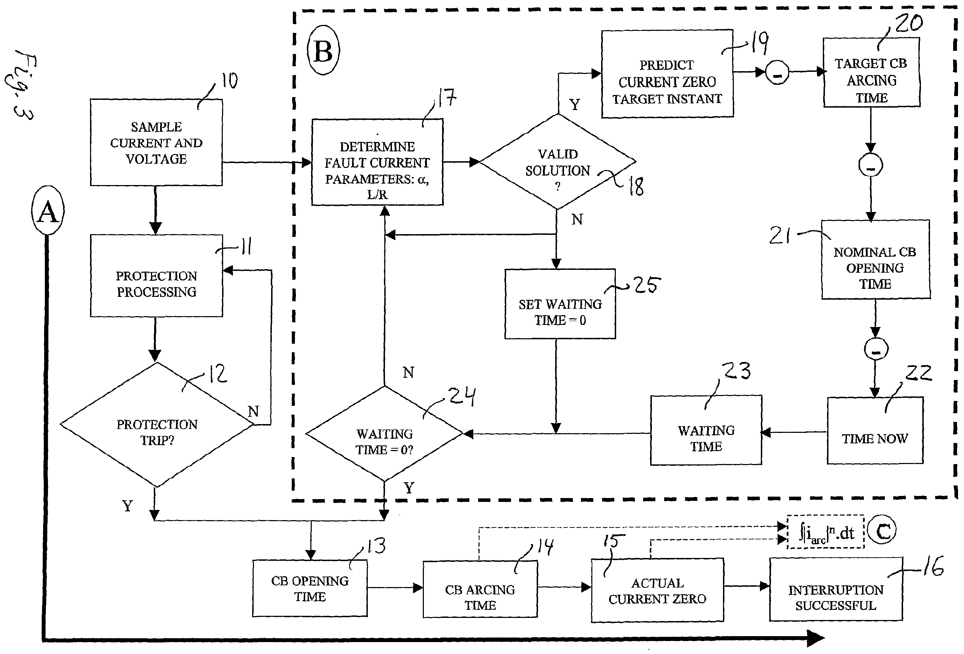

Figure 3 illustrates in functional terms a method for controlling the interruption of an interruption device according to an embodiment of the invention. In the case of non-controlled fault interruption, the process follows the bold arrow path A indicated in figure 3. The protection system samples the voltage and current in the current path, block 10, processes the measured voltage and current, block 11, and determines if there is a fault and if so sends an opening command to the breaker, block 12. The breaker begins to open upon receiving the opeining command and the current is interrupted at the first current zero occurring after the minimum arcing time has passed, block 13 -16.

The method proposed according to an embodiment of the invention, modifies this process by adding in the steps indicated in the boxed area B. The process steps attempt to determine how the fault current will develop in the future by estimating critical parameters, such as the fault initiation voltage phase angle, $\alpha$, and the source-to-fault resistance-to-inductance ratio, L/R, block 17. The estimated parameters are then used in the fault current model to create present and future estimated values of the fault current.

The validity of the so calculated estimated fault current is then checked by comparison to the sampled actual current, block 18. If the solution is deemed valid the estimated fault current behavior is then used to predict future current zero times, block 19, and then, by subtracting set values for the circuit breaker opening time, targeted arcing time and the present time, blocks 20, 21, 22, a waiting time is derived to until the opening command to the circuit breaker should be issued block 23, 24. The waiting time corresponds to the time period the opening command to the breaker should be delayed. If the protection system has decided to trip and the waiting time is zero, block 24 an opening command is issued. If the estimated current is found not to be acceptably valid, block 18, then the waiting time can be set to zero so as to not unduly inhibit opening of the breaker, block 25. The algorithm continuously processes current and voltage data, updating the estimated current model until current is interrupted.

It is important to note that in the process outlined in figure 3 the role of the additional control synchronization steps 2 is not a substitution of the protection system functions 1. The synchronization control of the circuit breaker arcing time is intended only to augment the interruption process and achieve optimization of the arcing time. The process of deciding whether or not a trip is required in the first place remains within the scope of the protection system. Such tripping decisions involve consideration of several other factors, not least co-ordination of protection operation zones within the power system.

In the example shown in figure 1 above, it can be seen that the earliest viable current zero is not the first current zero that is encountered after the circuit breaker arcing contacts part. Even if the breaker was tripped immediately upon the protection system going active, the minimum arcing time in this case is such that the breaker would fail to interrupt at the first current zero after arcing contact parting. One of the ultimate goals of the additional controlled interruption steps is to optimize the resultant arcing energy expended in the interrupter as indicated by C, the integral of the current during arcing.

A critical issue that arises from adding the controlled interruption process steps, particularly in conjunction with fault interruptions, is the need to not unnecessarily inhibit a protection operation, especially to the extent that may result in excessive prolongation of the total fault clearing time. There is a wide range of possible fault current behaviors and it is not certain that a specific controlled interruption algorithm can always determine a target switching solution within the likely response time of the protection system. It is therefore highly desirable to build in a check function within the controlled synchronization process to verify if a suitable convergent solution is obtainable and regulate the overall control process, as indicated by the validity check, block 18.

How the control is regulated in case of non-convergence towards a synchronized solution can be handled in one of two ways, either forcing the circuit breaker to trip, or inhibiting tripping.

A CFI system is intended to augment the overall interruption process and not replace the protection system functions. Even so, there can remain the problem that in some cases, due either to design limitations or outright system failure, the controlled interruption scheme may fail to arrive at a viable, convergent target solution before the protection system has determined a need to trip the circuit breaker. As such, strategies for the implementation of a controlled interruption scheme need to be established to manage its use in conjunction with an associated protection system. Four main implementation strategies for CFI are proposed here:

Type 1: Non-critical operation, clearing time, i.e. total fault interruption time plus arcing time, is optimized. Implies interruption is not critically dependent on correct algorithm operation and algorithm is optimized such that fastest possible clearing time takes precedence over optimal current loop arc energy selection.

Type 2: Non-critical operation, arc energy optimized. Implies interruption is not critically dependent on correct algorithm operation and algorithm is optimized such that optimal current loop arc energy selection is prioritized over total fault clearing time.

Type 3: Critical operation, clearing time optimized. Implies interruption is critically dependent on correct algorithm operation and algorithm is optimized such that fastest possible clearing time takes precedence over optimal current loop arc energy selection.

Type 4: Critical operation, arc energy optimized. Implies interruption is critically dependent on correct algorithm operation and algorithm is optimized such that optimal current loop arc energy selection is prioritized over total fault clearing time.

Types 1 and 2 fall under "non-critical" operation, meaning that successful interruption is not dependent on the performance of the synchronizing control scheme. Types 3 and 4 are schemes where interruption is entirely dependent on the proper function of the synchronizing control scheme. Types 1 and 3 are probably the more readily recognizable of the four proposed, as they demand that CFI is optimized with respect to the total fault clearing time i.e. the clearing time should not be prolonged compared to non-controlled interruption; optimization of the arc energy saving is a secondary concern. Types 2 and 4 are based upon optimization of the arc energy as a primary goal with the total clearing time being a secondary criterion.

In a critical CFI scheme, the operation of the arcing time synchronizing control is essential to achieve a successful interruption. Should the control scheme fail to arrive at a viable target solution within the protection response time, a decision must be taken either to permit the control scheme additional time to seek a viable solution, or defer tripping to a back-up circuit breaker. Prolonging the control scheme response time has itself limits, as the inter-zone protection settings on the power system will eventually interpret too long a trip delay as a failure to interrupt and initiate back-up protection operations. This may considerably exacerbate the impact of the original power system fault, resulting in either risks of transient instability or interruption of a larger than necessary portion of the network. Deferring the tripping more immediately to the backup scheme upon control scheme failure at expiration of the primary protection response time would at least mitigate the overall back-up clearing time and reduce the risk of wide area transient instability problems.

Critical CFI schemes therefore would require both a very high level of reliability and an ability to manage the widest range of switching cases. They in effect become an inherent part of the circuit breaker, as they are directly linked to the ability to achieve interruption. For such schemes to be attractive they need to offer significant performance benefits, such as lower total circuit breaker cost, increased ratings or more attractive interrupter technologies.

By contrast, in a non-critical CFI scheme, the circuit breaker is able to interrupt irrespective of the performance of the synchronizing control scheme. Optimum arcing time performance is achieved provided the control scheme reaches a viable solution within the protection system response time. In order not to delay tripping in the event of failure of the control scheme to reach a viable solution within the required time, the waiting time for tripping can be set to zero, permitting an immediate trip as soon as the protection system issues an opening command.

The proposed controlled switching algorithm is based on determination of the characteristic parameters of the fault current model described by the equation below:

$$i_f(t) = I_F \cdot [\sin(\omega t + \alpha - \phi) - \sin(\alpha - \phi)e(-t/\tau)] + I_{PF\alpha} \cdot e(-t/\tau) \qquad (1)$$

where

t = time
$I_F$ = peak value of steady state fault current.
$I_{PF\alpha}$ = the instantaneous pre-fault current magnitude at fault initiation, i.e. the value of current at fault initiation
$\omega = 2\pi f$; angular frequency (radian / second) of the power system
$\alpha$ = phase angle of the driving source voltage at fault initiation $\tan(\phi) = \omega L/R$; L = source-to-fault series inductance and R = source-to-fault series resistance
$\tau = L/R$ = time constant of the exponentially decaying asymmetrical component(s)

The key unknown characteristic parameters to be determined in equation 1 include $I_F$, $\alpha$, $\phi$ and $\tau$. It is clear that $\phi$ and $\tau$ are related through L, R and $\omega$. For the short time transient durations that the parameters must be calculated it is assumed that the power system frequency is constant.

Various methods could be applied to try and ascertain the unknown characteristic parameters. Discrete derivatives of the sampled current are possible to use in order to predict future zero crossing behavior, but such methods are inherently noise sensitive. What has been selected and examined in most detail is and found to be suitable is a method based on least mean square regression analysis. Advantages of Least Mean Square based algorithms, in the following denoted LMS include: flexibility to data window sizes, tolerance to noise and relatively straightforward mathematics.

Generally, a method for predicting future behavior of an alternating current after occurrence of a fault current according to an embodiment of the invention comprises: continuously sampling the current in the current path and saving sampled values of the current in a first moving sampling window, continuously sampling the voltage in the current path and saving sampled values of the voltage in a second moving sampling window, estimating one or more characteristic parameters for the current based on the data in the sampling window, predicting future values of the current based on said estimated parameters, an assumed value of the voltage phase angle, and a mathematical model of the current, continuously comparing the predicted values of the current with sampled values of the current from the same point in time, and on basis thereof decide whether the predicted current is sufficiently accurate, and if the predicted current is not sufficiently accurate, determine whether there is a lasting negative trend by determining whether the difference between the predicted and measured values increases over a predetermined number of sequential samples, and if is a lasting negative trend adjust the size of the sampling windows to discard values prior to the negative trend, and determine the point in time when the negative trend started, estimate the voltage phase angle at the point in time when the negative trend started based on said sampled values of the voltage, and predicting said future values of the current based on said estimate the voltage phase angle,

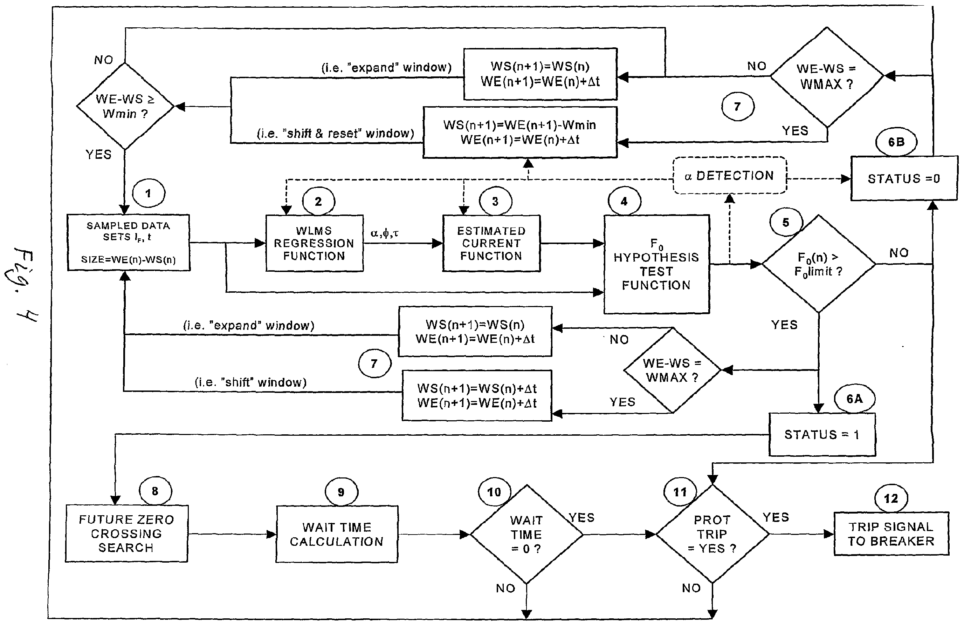

The general process followed within the proposed method is described in figure 4. The main steps of the process are explained in more detail below and indicated as a number within a circle the Figure 4.

Step 1. Data Sampling.

The proposed method is intended for continuous data processing and operation. Current, voltage and time data is continuously sampled and monitored using moving data windows and an assumed constant sample rate, S. Current and time discrete sample arrays are indexed from "window start", index ws, to "window end", index "we". Thus for each processing iteration,

Sample rate = S kHz; S ranging from 1 to 8kHz.
Sample time step $\Delta t = 1/S$ ms
Sample time array, $t = [t_{ws}, t_{ws}+1,...,t_{we}]$; where $t_{ws}+1 = t_{ws} + \Delta t$
Sampled current array, $I_s = [i(t_{ws}), i(t_{ws}+1),...,i(t_{we})]$

The setting and adjustment of "ws" and "we" per process iteration is described further in step 7. Voltage monitoring is restricted at this stage of implementation to tracking of voltage phase angle at time $t_{we}$ for estimation of fault initiation phase angle, $\alpha$, which is described further below.

Step 2. LMS Regression Function.

The sampled current array and estimated $\alpha$ value are inputs to the LMS regression function used to estimate the fault current $\phi$ and $\tau$ values according to a fault current model based on equation 1. As previously mentioned, equation 1 strictly requires non-linear regression techniques in order to ascertain its characteristic parameters, primarily due to the exponential terms including $\tau$. In order to simplify the regression process, it was decided to linearize and reduce equation 1 as described below. The proposed regression method is executed in four main steps:

1. Transform the current into an orthogonalized form to define key unknown parameters
2. Linearize the exponential component of the fault current in order to facilitate matrix least mean square regression estimation of unknown model parameters
3. Perform the least mean square regression calculation
4. Calculate the unknown orthogonal model parameters from the obtained LMS regression parameters

The $Ip_{F\alpha}$. e(-t/$\tau$) term affects the magnitude of the asymmetrical component, but is governed by the same time constant as the [sin(a - $\phi$)e(-t/$\tau$)] term and so in order to minimize the regression computation burden, equation 1 is simplified to:

$$i_f(t) = I_F. [\sin(\omega t + \alpha - \phi) - \sin(\alpha - \phi)e^{(-t/\tau)}] \qquad (2)$$

Note, however, that the $I_{PF\alpha}$. e(-t/$\tau$) term will be included later in the estimated current equation, using the estimation of the time constant, t, obtained from the regression process. Equation 2 can be factorized into its orthogonal components, which can be written in the general form:

$$i_f(t) = K1.\sin(\omega t) + K2\cos(\omega t) - K2\ e^{(-t/\tau)} \qquad (3)$$

Where

$$K1 = I_F.\cos(\alpha - \phi) = I_F.[\cos(\alpha).\cos(\phi) + \sin(\alpha).\sin(\phi)]$$

$$K2 = I_F.\sin(\alpha - \phi) = I_F.[\sin(\alpha).\cos(\phi) - \cos(\alpha).\sin(\phi)]$$

Solving equation 3 for K1, K2 and $\tau$ cannot be readily done using least means square matrix methods due to the exponential term K2 $e^{(-t/\tau)}$. However considering that processing of the sampled data is only over a sample of the current, it is possible to further "linearize" equation, using a limited Taylor series approximation of the exponential term,

$$e^{(-t/\tau)} = 1 - t/\tau \qquad (4)$$

Equation 2 can now be written in the general form,

$$i_f(t) = X1.\sin(\omega t) + X2.\cos(\omega t) - X3.1 + X4.t \qquad (5)$$

The form of equation 5 is readily adapted to a least mean square regression matrix method to solve for $X_1$, $X_2$, $X_3$ and $X_4$. Note that the coefficients of equation 5 have been intentionally named differently from those in equation 3 as the two equations, while similar, are not identical, primarily due to the Taylor series approximation of the exponential term. The X terms are related to the K terms by the following equations. Knowing $\alpha$, $K_1$, $K_2$ and $K_3$ can be then be derived as follows,

$$K1 = X1.\cos(\alpha) - X2.\sin(\alpha) \qquad (6)$$

$$K2 = X1.\sin(\alpha) - X2.\cos(\alpha) \qquad (7)$$

$$1 / |\tau| = \omega / |X2/X1| \qquad (8)$$

It is important also to recognize that equations 6, 7, 8 are valid only in the context of the driving source reference voltage defined by $u(t) = U_{pk}.\sin(\omega t + \alpha)$, which is the defined frame of reference to the orthogonal transformation made through equation 3.

According to this embodiment of the invention a Weighted Least Means Square method, in the following denoted WLMS, is used for solving equation 5, using a unitary weights matrix, W, as described in standard linear algebra or statistical analysis texts, for example in a book by Strang G., "Linear Algebra and its Applications", 3rd Edition, Brooks/Cole Thomson Learning Inc., 1988. It should be noted that K1, K2 and $1/|\tau|$ are only least means square estimates of the "true" $\phi$ and $\tau$ terms that described the fault current behavior. Nevertheless they provide a means to construct an estimated model of the current that can then be used for predicting future current behavior.

There are three main differences proposed in this work, compared to more conventional orthogonal least means square protection algorithm approaches: weighted least means squares as opposed to ordinary least means squares, the use of the Taylor series approximation of the exponential term in order to get the system of equations into a form that is more easily processable in matrix algebra, and the inclusion of a in the fault current model.

A further consideration in regard to the WLMS approach is the total computational burden. It is optimal if each WLMS calculation can be completed within the time to obtain each new sample data point i.e. the matrix computations, estimated current generation and checking, future current zero search and waiting time calculations should be completed within each "$\Delta t$" sampling time period. Thus if data is sampled at say 2kHz, each iteration of the above calculations optimally need to be completed within 0.5ms.

Most of the calculation burden is found within matrix multiplication and inversion in connection with the WLMS computation. However it should be noted that the all matrices needed contain values that can be easily pre-defined and thus the calculations can be done in advance and stored in a memory - only the size of the matrices varies according to the number of data samples and there are defined limits set for minimum and maximum data window sizes.

Step 3. Estimated Current Function:

The estimated current is constructed using the most recently estimated values of $\alpha$, $I_{PF}$,-, $I_F.\cos(\alpha - \phi)$, $I_F. \sin(\alpha - \phi)$ and $\tau$ obtained from the WLMS method. Factorizing equation 1,

$$i_f(t) = I_F. \, [\sin(\omega t)\cdot\cos(\alpha - \phi) + \cos(\omega t)\cdot\sin(\alpha - \phi) - \sin(\alpha - \phi)\cdot e(-t/\tau)] + I_{PF\alpha}. \, e(-t/\tau) \quad (6)$$

It is the above form of the current model equation that is then used to create the estimated current, test, over the same time period as the originally samples $i_f$.

Step 4. FO Hypothesis Test

Having derived an estimated model of the fault current, it remains to check the validity of the modeled current to the sampled current. There are several established statistical methods applied in linear regression to verify the suitability or correlation of a model to sampled data. Most such tests are derived from analysis of the residuals between the model function and the sampled data set.
A known test for linear regression models is the so-called "FO hypothesis test", otherwise referred to as "test for significance of regression", as described by Montgomery Douglas C., and Runger George C., in "Applied Statistics and Probability for Engineers", 2nd Edition, John Wiley & Sons, Inc., New York, 1999. The FO test attempts to determine the validity or otherwise of two hypotheses, H0 and H1. H0 is a "zero coefficient" hypothesis that supposes that all coefficients in a proposed model are equal to zero. H1 is the alternate hypothesis that supposes at least one coefficient has a non-zero value. The FO test is defined as follows:

$$F_0 = \frac{SS_R/k}{SS_E/(n-p)}$$

$$(9)$$

where $SS_R$ is the regression sum of the squares, $SS_E$ is the error sum of the squares, k is number of coefficients used in regression, n is the number of sampled values tested and p is the number of terms used in the regression,

$$SS_R = \sum_{i=1}^{n} (\hat{y}_i - \bar{y})^2$$

$$SS_E = \sum_{i=1}^{n} (y_i - \hat{y}_i)^2$$

$$(10)$$

where

$y_i$ = the $i_{th}$ estimated model value
$\bar{y}_i$ = the mean of the sampled values
$y_i$ = the $i_{th}$ sampled value

It was found through simulations that the FO values obtained from 10 applied to the model described by equation 9 displayed a strong relationship to the eventual zero-crossing errors between the estimated and actual currents. As such the F0-test provided a useful means of determining the suitability of the derived current model for identifying future possible current zero targets and could further be used to regulate the algorithm on the basis of whether or not a suitable current model was continually being achieved. F0 values in the range of 30-50 were found to co-incide well with future zero-crossing errors less than 1 ms. As such an F0 limiting value was set to determine whether the derived current model should be adopted during an iteration for future current zero time prediction.

Step 5. F0 Result Check

The F0 result check involves checking if the latest obtained F0 result is above or below a set limit value. If the F0 value is above the limit value, the controlled switching zero-crossing search and waiting time calculations can proceed based on the corresponding modeled current. If not, the control process is interrupted and the data sampling window adjusted on the assumption that there is data in the sample set that is inconsistent with a single model solution i.e. a possible new transient.

Step 6. Status Setting

A status flag is used to control whether the algorithm proceeds to a future target zero-crossing search and waiting time calculation or whether the process is interrupted due to having a presently inadequate estimated current model solution.
If the F0 value is above the limit value, the status flag is set to "1", block 6A, indicating the algorithm may proceed with a predicted zero-crossing search and associated waiting time calculation. If the F0 value is below the limit value, the status flag is set to "0", block 6B, indicating new data sampling window limits are required and a new current model estimation is required.

Step 7. Data Window Size Adjustment:

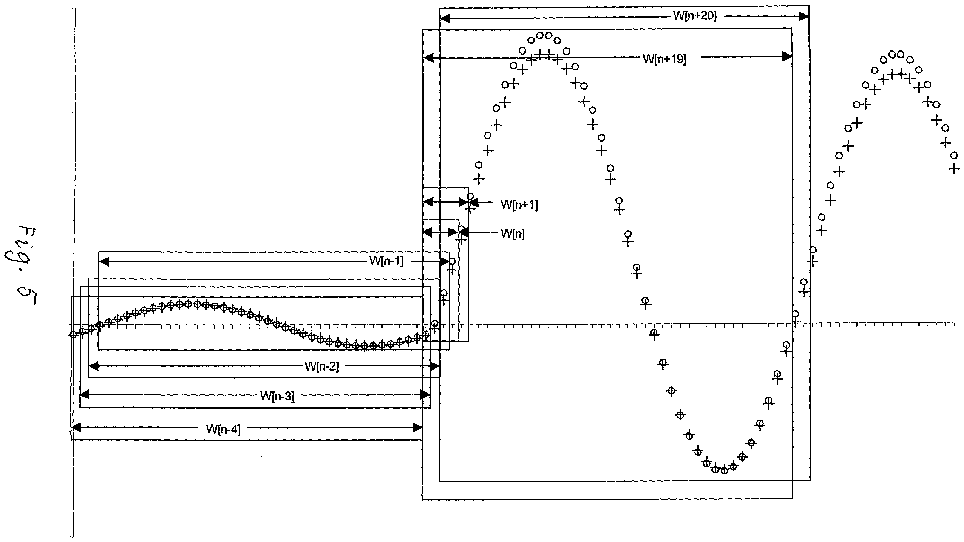

Sampled data of current and voltage is stored in moving data windows adapted for storing a maximum number of sampled values. When the window is full, the oldest value is rejected and the new value is stored instead. The size of the windows is adjustable, which means that the number of stored values can be varied.
The data sampling window is bounded by two indexes, "ws" being "window start" and "we" being window end. Maximum and minimum data window sizes, denoted WMAX and WMIN, are set in order to optimize the overall process.
WMAX is normally set to data window equal to one power frequency cycle, as this provides stability in the resultant F0 values for a stable condition, even in presence of signal noise, yet restricts the maximum matrix dimensions needed for the WLMS calculations.
WMIN must be at least equal to the number of coefficients in matrix in order to obtain a solvable set of equations. The upper limit on WMIN is limited by the minimum expected protection system response time. In general WMIN is set to either one half, or one quarter power frequency cycle of data.
Data window size adjustment depends on several factors and as shown in Figure 5, the data window size adjustment is handled in three modes depending on the status of the control process; "expand window", "shift window" or "shift and reset window". In figure 5 sampled current values are marked with "o", and derived modeled current is marked with an "+". The windows are denoted W[n - 1] - W[n+20].
If the window is less than WMAX the window is expanded on data sample prior to the next iteration i.e. "ws" is unchanged and "we" is incremented one time step, Dt. If the window is at WMAX the window and F0 result is acceptable, the window is shifted one time step i.e. "ws" and "we" are both incremented one time step, $\Delta t$. If the window is at WMAX and the F0 result is unacceptable, the window is reset to a new minimum window size commencing at the last data sample i.e. "ws" is set to the last "we" value and "we" is incremented to the next incoming sample. Note that the process of sampling is assumed to be continuous and thus "we" is continually updated to the next incoming sample. The total window size adjustments are made on the window start index "ws".
In figure 5 window, W[n], is the first window adjusted following the initiation of the fault. Window, W[n-4], is the last full size (WMAX) window before the fault starts. Windows, W[n-3] to W[n-1] contain mostly pre-fault and some fault current data samples. The algorithm determines, from the decreasing F0 values in windows W[n-3] to W[n-1], that a fault has occurred close to the time of the last sample in window W[n-4] and for window W[n] resets the start window sample to be from the last sample of W[n-4] and increments the window end by the next incoming sample.

Step 8. Future zero crossing search

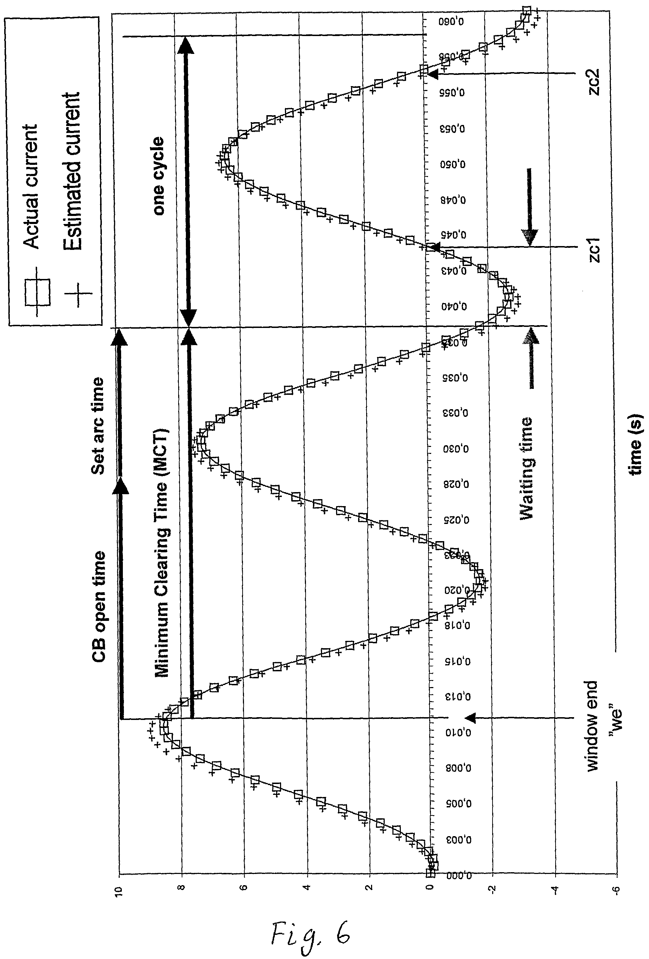

Provided the F0 result is acceptable and the status flag set to "1" the estimated current described by equation 6 is then used to create an array of future current values. This array is then searched for future zero-crossings as illustrated in figure 6. The zero-crossing search window is started allowing for programmed circuit breaker opening plus target arcing time and ended one power frequency cycle later. On the basis of implementing a clearing time optimized CFI scheme, the earliest detected current zero within this window is then used as the target for calculating the required waiting time to send an opeining command to the circuit breaker in order to achieve synchronized opening corresponding to the targeted "optimum" arcing time.
Figure 6 shows the principle used for finding future possible current zeros to which interruption with optimum arcing time could be synchronized. The crosses denote the estimated current and the squares the actual current. The method uses the current model to calculated future values of the current from the end of the existing data sampling window, time instant "we", to at least a time equal to the sum of the breaker opening time and the set arcing time, which corresponds to what is termed the minimum clearing time, and one power frequency cycle. The algorithm then searches for current zeroes between the end of the minimum clearing time and the additional power frequency cycle. This ensures the algorithm can detect at least one viable current zero beyond the earliest possible minimum clearing time. If more than one current zero is found, the choice of which current zero to target is made depending on if the algorithm is configured for clearing time optimization, in which case the first current zero is used, or configured for arc energy optimization, in which case the current zero corresponding to the lowest arc integral result with the set arcing time is chosen.

Step 9. Waiting Time Calculation:

As indicated in figure 6, the waiting time is easily calculated from the time remaining between the earliest clearing time, i.e. breaker opening time plus arcing time, at time of calculation and the earliest predicted future current zero time.

Step 10. Waiting Time Check

Once the waiting time has iterated to less than one iteration time step, i.e. near zero time, then it may be possible to send an opening command to the circuit breaker. However, the decision whether to open or not remains with the protection system.
Note that if during an iteration of the process the algorithm fails to reach an acceptable F0 value the waiting time is also set to zero to permit immediate tripping by the protection system, if so determined.

Step 11. Protection Response Check

Once the waiting time has reached zero, a check is made of whether the protection system has determined a trip operation is required. If there is no protection trip at that time, the algorithm proceeds with further iteration(s).

Step 12. Opening Command to Circuit Breaker:

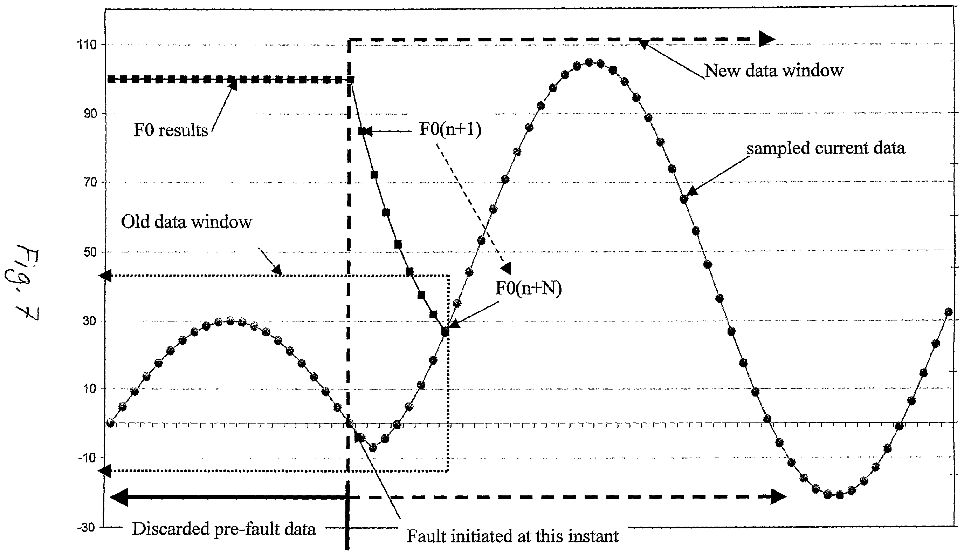

Once the protection system has determined a trip operation is required and the waiting time has reached zero, the opening command is sent to the circuit breaker.
In the following the detection of $\alpha$ is described in more detail. In figure 4 and equations 1 to 5 it is assumed that the fault initiation voltage phase angle, $\alpha$, is "known". It is not necessary that $\alpha$ be determined directly by the same process as for the other fault current parameters, but may be provided as a separate input by a separate detection process.
It may however be determined via the above process by checking the F0 value behavior, as shown in figure 7. The proposed and tested method for fault initiation and thus $\alpha$-detection, looks at the trend behavior in successive F0 results. If a specified number of successive F0 results are seen to be decreasing by a specified rate, e.g. by a factor, k, then such a trend can be taken as an indicator that the algorithm is managing less well to reach a good parameter estimation with the most recently acquired data. Therefore, there is an increasing probability that some change in the behavior of the sampled current has occurred.
The F0 trend analysis for fault initiation and a-detection is for example set up as follows. Assume F0(t(n)) denotes the F0 result at time instant, t(n), which corresponds to the fault initiation instant. A rate of decay factor, k, is set in conjunction with a fixed number, m, of successive values of F0 for which the trend analysis is made. If the condition in following equation is true,

$$k * F0(t(n+m)) < \ldots < k * F0(t(n+1) < F(t(n)) \qquad (11)$$

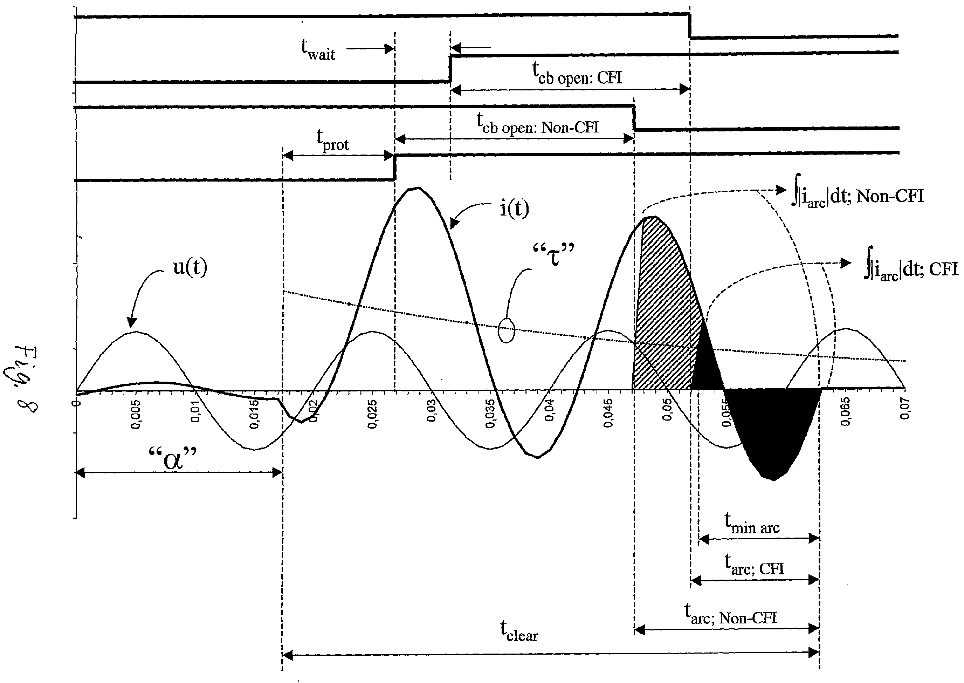

then it is assumed a fault initiated at time t(n), and then the status of the control algorithm is set to 0, i.e. "Not OK result", and the start of the data sampling window is reset to coincide with time instant t(n). Investigation needs to be made for the choices for the decay rate parameters k and m that can operate with acceptable reliability in a potentially noisy signal environment.
A wide range of parameters influences the performance of a controlled fault interruption scheme. Figure 8 illustrates some important fault current system and circuit breaker related parameters for a specific fault interruption case. The two key fault current system parameters indicated in Figure 8 are the phase angle $\alpha$ on the voltage at which the fault is initiated, and the time constant $\tau$ of the asymmetrical component of the fault current. The phase angle is measured from the positive slope zero crossing of the driving source voltage u(t). While $\alpha$ may have a full range of 0-2p or 0-360 electrical degrees, for a given set of fault cases the probability distribution of $\alpha$ within this range could also be considered.

The other parameters of importance in Figure 8 are the protection response time, $t_{prot}$, and the total fault clearing time, $t_{clear}$. The protection response time is defined as the time from fault initiation until the protection system issues an opening command to the circuit breaker. The total fault clearing time is the time from fault initiation until successful fault current interruption. Total fault clearing time is of important in protection system planning as it impacts on the potential stability of the power system, especially during transient instability conditions. It is generally desired to have the shortest possible total fault clearing time in order to avoid the power system under a major transient developing into a non-stable or potentially "collapsing" state. Total fault clearing time is of course governed by the protection response time, the opening and arcing times of the circuit breaker.

The key circuit breaker parameters impacting on controlled fault interruption are the circuit breaker opening time $t_{open}$ and minimum arcing times $t_{min}$ arc. The opening time of a circuit breaker is defined as the time from opeining command starting to the parting of the circuit breaker arcing contacts. Circuit breaker opening times vary both between different designs and within any specific design. In 8 two breaker opening times are shown, tcb open: Non-CFI and tcb open: CFI, standing for the opening time for non-controlled fault interruption and the opening time for controlled fault interruption. The minimum arcing time $t_{min}$ of the circuit breaker may vary depending on the specific nature of the fault current to be interrupted. A desired arcing time $t_{arc}$ is preselected. In figure 7 the desired arcing time is chosen as the minimum arcing time plus a safety margin.

Figure 8 discloses the arc integral for the non-CFI case and the CFI case. As seen from the figure the arc integral is essentially reduced for the CFI case.

It is to be pointed out that, even though the invention is particularly useful for obtaining a well controlled arcing time for conventional high voltage interrupters, such as $SF_6$ circuit breakers, it is also useful in connection with all types of interruption devices that interrupts at natural current zero crossings, i.e. gas-plasma, vacuum or power electronic interrupters. A current interruption device is to be given a broad sense and covers not only such ones having a mechanical movement between different parts for obtaining an opening through physical separation of two parts in the current path, but also semiconductor devices, such as IGBTs or the like, which open by going to blocking state and by that breaking the current there through, and so called transfer switches through which a current in a current path may be broken upon occurrence of a fault current in the current path for switching in another current path instead to a load or the like.

The present invention is not limited to the embodiments disclosed but may be varied and modified within the scope of the following claims. For example other mathematic methods can be applied to resolve the characteristic parameters and behavior of the fault current, for example iterative non-linear regression methods, Gauss-Seidel methods, Newton-Raphson methods or other numercial analysis methods by one skilled in the art.

**Claims**

1. A method for predicting future behavior of an asymmetric fault current in a current path, wherein the method comprises:

   - continuously sampling the current (i(t)) in the current path,
   - predicting future values of the current based on the sampled current values and a mathematical model of the current, **characterized in that** the method further comprises:
   - saving the sampled values of the current in an adaptively-sized moving sampling window,
   - comparing the predicted values of the current with sampled values of the current from the same point in time, and on basis thereof
   - determined whether or not a fault current has occurred in the current path, and upon detecting that a fault current has occurred:

     o adjusting the moving sampling window to discard current values prior to the fault current, and
     o predicting future values of the fault current based on the current values in the adjusted sampling window and the mathematical model of the current.

2. A method according to claim 1, wherein the prediction of the current comprises:

   - estimating one or more characteristic parameters for the current based on the data in the sampling window,

- estimating the voltage phase angle ($\alpha$) at the point in time when the fault current started, and
- predicting future values of the fault current based on said estimated characteristic parameters and voltage phase angle.

3. A method according to claim 1 or 2, wherein the method further comprises:

- continuously sampling the voltage in the current path and saving sampled values of the voltage in a second moving sampling window, and if it has been determined that a fault current has occurred:

    ◦ determining the point in time when the fault current started,
    ◦ estimating the voltage phase angle ($\alpha$) at the point in time when the fault current started based on said sampled values of the voltage, and
    ◦ predicting said future values of the current based on said estimated voltage phase angle.

4. A method according to claim 2 or 3, wherein the prediction of future values of the current before a fault current has occurred is based on an assumed value of the voltage phase angle ($\alpha$).

5. A method according to any of the previous claims, wherein the method comprises:

- continuously deciding whether the predicted current is sufficiently accurate based on said comparison of the predicted and sampled current values, and if the predicted current is not sufficiently accurate:
- determining whether there is a lasting negative trend in the accuracy of the prediction and on basis thereof decide if a fault current has occurred, and
- adjusting the sampling window to discard current values prior to the negative trend.

6. A method according to claim 3 and 5, wherein the method comprises determining the point in time when the fault current started by determining the point in time when the negative trend started, and estimating the voltage phase angle ($\alpha$) at the point in time when the negative trend started.

7. A method according to any of the previous claims, wherein said detecting when a fault current occurs comprises: determining whether the difference between the predicted and measured current values increases over a predetermined number of sequential samples, and if so a fault current is detected

8. A method according to any of the previous claims, wherein the method comprises estimating one or more future zero crossings (Z1 - Z5) of the fault current based on the predicted future values of the current, and based on the estimated zero crossings controlling the action of an interruption device arranged in the current path for interrupting the current upon command, in order to optimize the current interruption.

9. A method according to claim 8, wherein the interruption device is an arc based interruption device adapted to open upon command, and the method comprises synchronizing the opening of the interruption device with respect to the estimated future zero crossings of the current in order to achieve a desired arcing time.

10. A method according to claim 9, wherein said interruption device has a certain opening time ($t_{open}$), and said synchronizing includes delaying the opening command to the interruption device with respect to the sum of the opening time of the interruption device and a desired arcing time ($t_{arc}$).

11. A method according to claim 10, wherein the method comprises calculating a time period for the delay ($t_{wait}$), based on the difference between a selected estimated current zero crossing and the sum of the desired arcing time ($t_{arc}$).and the opening time ($t_{open}$) of the interruption device, and repeatly calculating a new time period for the delay of the opening command.

12. A method according to claim 11, wherein the method comprises continuously comparing the predicted values of the current with sampled values of the current from the same point in time, and on basis thereof deciding whether the predicted current is sufficiently accurate or not, and if the predicted current is not sufficiently accurate the time period for the delay ($t_{wait}$) of the opening command is set to zero.

13. A method according to claim 12, wherein the method comprises:

- calculating a time constant ($\tau$) for the fault current based on the sampled values of the current,
- calculating the magnitude of the fault current ($i_{arc}$) for at least the two earliest estimated current zero crossings viable for interruption,
- calculating an arc current integral for each of said two earliest estimated current zero crossings, based on the mathematical model of the current, the calculated time constant and the calculated magnitude of the fault current, wherein the upper time boundary is the estimated current zero crossing and the lower time boundary is the upper time boundary minus the desired arcing time,
- comparing the calculated arc current integrals, and
- calculating the time period for the delay of the opening command based the current zero crossing corresponding to the lowest of the calculated arc current integrals.

**14.** A method according to any of the previous claims, wherein the method comprises estimating the fault current exponential component time constant ($\tau$) by means of a truncated Taylor series approximations of the exponential component, and predicting future values of the fault current based on said estimated time constant.

**15.** A computer program directly loadable into the internal memory of a computer, comprising software for performing the steps of any of the claims 1 - 14.

**16.** A computer readable medium, having a program recorded thereon, where the program is to make a computer perform the steps of any of the claims 1 - 14, when said program is run on the computer.

**17.** An apparatus for predicting future behavior of an asymmetric fault current in a current path (2), the apparatus comprises:

- a member (1) adapted to continuously sample the current in the current path, and
- a predictor (4) arrangement adapted to predict future values of the current in the current path based on the sampled current values and a mathematical model of the current,

**characterized in that** the apparatus further comprises:

- a fault current detector (5) adapted to compare the predicted current values with sampled current values from the same point in time, and on basis thereof determined whether or not a fault current has occurred in the current path, and

that said member (1) is adapted to save the sampled values of the current in an adaptively-sized moving sampling window and upon detecting a fault current, adjust the sampling window to discard current values prior to the fault current, and said predictor (4) arrangement is adapted to predict future values of the fault current based on the current values in the adjusted sampling window.

**18.** An apparatus according to claim 17, **characterized in that** said predictor (4) arrangement is adapted to estimate one or more characteristic parameters for the current based on the data in the sampling window, estimating the voltage phase angle ($\alpha$) at the point in time when the fault current started, and to predict the future values of the fault current based on said estimated characteristic parameters and voltage phase angle.

**19.** An apparatus according to claim 17 or 18, **characterized in that** the apparatus further comprises:

- a second member (2) adapted to continuously sample the voltage in the current path and to save sampled values of the voltage in a second moving sampling window, and
- that said predictor arrangement (4) is adapted to, upon determining that a fault current has occurred, determining the point in time when the fault current started, estimating the voltage phase angle at the point in time when the fault current started based on said sampled values of the voltage, and to predict said future values of the current based on said estimated voltage phase angle.

**20.** An apparatus according to claim 18 or 19, **characterized in that** said predictor arrangement (4) is adapted to predict the future values of the current, before a fault current has occurred, based on an assumed value of the voltage phase angle.

**21.** An apparatus according to any of the claims 17 - 20, **characterized in that** said fault current detector (5) is adapted to continuously decide whether the predicted current is sufficiently accurate or not, based on said comparison of the predicted and sampled values, and if the predicted current is not sufficiently accurate the fault current detector is adapted to determine whether there is a lasting negative trend in the accuracy of the prediction, and on basis thereof decide whether a fault current has occurred or not, and said first mentioned member is adapted to, upon detecting a fault current, adjust the sampling window to discard current values prior to the negative trend.

22. An apparatus according to claim 19 and 21, **characterized in that** said fault current detector (5) is adapted to determine the point in time when the fault current started by determining the point in time when the negative trend started, and to estimate the voltage phase angle ($\alpha$) at the point in time when the negative trend started.

23. An apparatus according to any of the claims 17 - 22, **characterized in that** said fault current detector (5) is adapted to determine whether the difference between the predicted and measured current values increases over a predetermined number of sequential samples, and on bases thereof determining whether a fault current has occurs or not

24. An apparatus according to any of the claims 17 - 23, **characterized in that** it comprises

- a zero crossing estimator (6) adapted to estimate future zero crossings of the fault current based on the predicted future values of the current, and
- a control device (7) adapted to control the action of an interruption device (8), arranged in the current path (2) and adapted to upon command interrupt the current in the current path, based on the estimated current zero crossings in order to optimize the current interruption.

25. An apparatus according to claim 24, **characterized in that** the interruption device (8) is an arc based interruption device adapted to open upon command, and the control device is adapted to synchronize the opening of the interruption device with respect to the estimated future current zero crossings of the current in order to achieve a desired arcing time.

26. An apparatus according to claim 25, **characterized in that** said interruption device (8) has a certain opening time, and said control device (7) is adapted to delay the opening command to the interruption device with respect to the sum of an opening time of the interruption device and a desired arcing time.

27. An apparatus according to claim 26, **characterized in that** said control device (7) is adapted to calculate a time period for the delay, based on the difference between a selected estimated current zero crossing and the sum of the desired arcing time and the opening time of the interruption device, and to repeatly calculating a new time period for the delay of the opening command.

28. An apparatus according to claim 27, **characterized in that** said control device (7) is adapted to continuously decide whether the predicted current is sufficiently accurate or not based on said comparison of predicted and sampled values of the current from the same point in time, and if the predicted current is not sufficiently accurate the time period for the delay of the opening command is set to zero.

29. An apparatus according to claim 28, **characterized in that** said control device (7) is adapted to calculate a time constant ($\tau$) for the fault current based on the sampled values of the current, to calculate the magnitude of the fault current for at least the two earliest estimated current zero crossings viable for interruption, to calculate an arc current integral for each of said two earliest estimated current zero crossings, based on the mathematical model of the current, the calculated time constant and the calculated magnitude of the fault current, wherein the upper time boundary is the estimated current zero crossing and the lower time boundary is the upper time boundary minus the desired arcing time, to compare the calculated arc current integrals, and to calculate the time period for the delay of the opening command based the current zero crossing corresponding to the lowest of the calculated arc current integrals.

30. An apparatus according to claim any of the claims 17 - 29, **characterized in that** said predictor arrangement (4) is adapted to estimate the fault current exponential component time constant ($\tau$) by means of a truncated Taylor series approximations of the exponential component, and to predict future values of the fault current based on said estimated time constant.

31. Use of an apparatus according to any of the claims 17 - 30 for predicting future behavior of an asymmetric fault current in a current path for electricity supply within industry or in distribution or in transmission or in electrical railway networks.

32. Use of an apparatus according to any of the claims 17 - 30 for predicting future behavior of an asymmetric fault current in a current path having a voltage between 1-800kV.

33. Use of an apparatus according to any of the claims 17 - 30 for determining future current zero crossings for the purpose of controlling the opening time of an interruption device.

34. Use of an apparatus according to any of the claims 17 - 30 for determining future current crossings for the purpose of controlling the arcing time of an arc based interruption device.

35. Use of an apparatus according to any of the claims 17 - 30 for determining future current crossings for the purpose of controlling the commutation time of an interruption device.

**Patentansprüche**

1. Verfahren zum Vorhersagen eines zukünftigen Verhaltens eines asymmetrischen Fehlerstroms in einem Stromweg, wobei das Verfahren Folgendes umfasst:

- kontinuierliches Abtasten der Stromstärke (i(t)) in dem Stromweg,
- Vorhersagen zukünftiger Werte der Stromstärke basierend auf den abgetasteten Stromstärkewerten und einem mathematischen Modell der Stromstärke, **dadurch gekennzeichnet, dass** das Verfahren ferner Folgendes umfasst:
- Speichern der abgetasteten Werte der Stromstärke in einem adaptiv bemessenen, sich bewegenden Abtastfenster,
- Vergleichen der vorhergesagten Werte der Stromstärke mit abgetasteten Werten der Stromstärke von demselben Zeitpunkt und basierend darauf
- Bestimmen, ob ein Fehlerstrom in dem Stromweg aufgetreten ist oder nicht, und dann, wenn detektiert wird, dass ein Fehlerstrom aufgetreten ist:

° Anpassen des Abtastfensters, um Stromstärkewerte vor dem Fehlerstrom zu verwerfen, und
° Vorhersagen zukünftiger Werte des Fehlerstroms basierend auf den Stromstärkewerten in dem angepassten Abtastfenster und dem mathematischen Modell der Stromstärke.

2. Verfahren nach Anspruch 1, wobei die Vorhersage der Stromstärke Folgendes umfasst:

- Schätzen eines oder mehrerer charakteristischer Parameter für die Stromstärke basierend auf den Daten in dem Abtastfenster,
- Schätzen des Spannungsphasenwinkels ($\alpha$) zu dem Zeitpunkt, zu dem der Fehlerstrom begann, und
- Vorhersagen zukünftiger Werte des Fehlerstroms basierend auf den geschätzten charakteristischen Parametern und dem Spannungsphasenwinkel.

3. Verfahren nach Anspruch 1 oder 2, wobei das Verfahren ferner Folgendes umfasst:

- kontinuierliches Abtasten der Spannung in dem Stromweg und Speichern von abgetasteten Werten der Spannung in einem zweiten, sich bewegenden Abtastfenster, und dann, wenn bestimmt worden ist, dass ein Fehlerstrom aufgetreten ist:

° Bestimmen des Zeitpunkts, zu dem der Fehlerstrom begann,
° Schätzen des Spannungsphasenwinkels ($\alpha$) zu dem Zeitpunkt, zu dem der Fehlerstrom begann, basierend auf den abgetasteten Werten der Spannung, und
° Vorhersagen der zukünftigen Werte des Fehlerstroms basierend auf dem geschätzten Spannungsphasenwinkel.

4. Verfahren nach Anspruch 2 oder 3, wobei die Vorhersage zukünftiger Werte der Stromstärke, bevor ein Fehlerstrom aufgetreten ist, auf einem angenommenen Wert des Spannungsphasenwinkels ($\alpha$) basiert.

**5.** Verfahren nach einem der vorhergehenden Ansprüche, wobei das Verfahren Folgendes umfasst:

- kontinuierliches Entscheiden basierend auf dem Vergleich der vorhergesagten und abgetasteten Stromstärkewerte, ob die vorhergesagte Stromstärke ausreichend genau ist, und dann, wenn die vorhergesagte Stromstärke nicht ausreichend genau ist:
- Bestimmen, ob es einen bleibenden negativen Trend in der Genauigkeit der Vorhersage gibt, und basierend darauf Entscheiden, ob ein Fehlerstrom aufgetreten ist, und
- Anpassen des Abtastfensters, um die Stromstärkewerte vor dem negativen Trend zu verwerfen.

**6.** Verfahren nach Anspruch 3 und 5, wobei das Verfahren ein Bestimmen des Zeitpunkts, zu dem der Fehlerstrom begann, durch Bestimmen des Zeitpunkts, zu dem der negative Trend begann, und ein Schätzen des Spannungsphasenwinkels ($\alpha$) zu dem Zeitpunkt, zu dem der negative Trend begann, umfasst.

**7.** Verfahren nach einem der vorhergehenden Ansprüche, wobei das Detektieren, wenn ein Fehlerstrom auftritt, Folgendes umfasst: Bestimmen, ob die Differenz zwischen den vorhergesagten und den gemessenen Stromstärkewerten über eine vorbestimmte Anzahl von aufeinanderfolgenden Abtastwerten ansteigt, und dann, wenn dies zutrifft, Detektieren eines Fehlerstroms.

**8.** Verfahren nach einem der vorhergehenden Ansprüche, wobei das Verfahren ein Schätzen eines oder mehrerer zukünftiger Nulldurchgänge (Z1 - Z5) des Fehlerstroms basierend auf den vorhergesagten zukünftigen Werten der Stromstärke und, basierend auf den geschätzten Nulldurchgängen, ein Steuern eines Einsatzes einer in dem Stromweg angeordneten Unterbrechungsvorrichtung zum Unterbrechen des Stroms auf Befehl, um die Stromunterbrechung zu optimieren, umfasst.

**9.** Verfahren nach Anspruch 8, wobei die Unterbrechungsvorrichtung eine lichtbogenbasierte Unterbrechungsvorrichtung ist, die dazu ausgelegt ist, sich auf Befehl zu öffnen, und das Verfahren ein Synchronisieren des Öffnens der Unterbrechungsvorrichtung in Bezug auf die geschätzten zukünftigen Nulldurchgänge der Stromstärke umfasst, um eine gewünschte Lichtbogenzeit zu erreichen.

**10.** Verfahren nach Anspruch 9, wobei die Unterbrechungsvorrichtung eine gewisse Öffnungszeit ($t_{open}$) aufweist und das Synchronisieren ein Verzögern des Öffnungsbefehls an die Unterbrechungsvorrichtung in Bezug auf die Summe der Öffnungszeit der Unterbrechungsvorrichtung und einer gewünschten Lichtbogenzeit ($t_{arc}$) umfasst.

**11.** Verfahren nach Anspruch 10, wobei das Verfahren ein Berechnen einer Zeitspanne für die Verzögerung ($t_{wait}$) basierend auf der Differenz zwischen einem ausgewählten geschätzten Stromnulldurchgang und der Summe der gewünschten Lichtbogenzeit ($t_{arc}$) und der Öffnungszeit ($t_{open}$) des Unterbrechungsvorrichtung und ein wiederholtes Berechnen einer neuen Zeitspanne für die Verzögerung des Öffnungsbefehls umfasst.

**12.** Verfahren nach Anspruch 11, wobei das Verfahren umfasst: kontinuierliches Vergleichen der vorhergesagten Werte der Stromstärke mit abgetasteten Werten der Stromstärke von demselben Zeitpunkt und basierend darauf Entscheiden, ob die vorhergesagte Stromstärke ausreichend genau ist oder nicht, umfasst, und dann, wenn die vorhergesagte Stromstärke nicht ausreichend genau ist, Setzen der Zeitspanne für die Verzögerung ($t_{wait}$) des Öffnungsbefehls auf null.

**13.** Verfahren nach Anspruch 12, wobei das Verfahren Folgendes umfasst:

- Berechnen einer Zeitkonstante ($\tau$) für den Fehlerstrom basierend auf den abgetasteten Werten der Stromstärke,
- Berechnen des Betrags des Fehlerstroms ($i_{arc}$) für mindestens die beiden frühesten geschätzten Stromnulldurchgänge, die für eine Unterbrechung brauchbar sind,
- Berechnen eines Lichtbogenstromintegrals für jeden der beiden frühesten geschätzten Stromnulldurchgänge basierend auf dem mathematischen Modell der Stromstärke, der berechneten Zeitkonstante und dem berechneten Betrag des Fehlerstrom, wobei die obere Zeitgrenze der geschätzte Stromnulldurchgang ist und die untere Zeitgrenze die obere Zeitgrenze minus der gewünschten Lichtbogenzeit ist,
- Vergleichen der berechneten Lichtbogenstromintegrale und
- Berechnen der Zeitspanne für die Verzögerung des Öffnungsbefehls basierend auf dem Stromnulldurchgang, der dem geringsten der berechneten Lichtbogenstromintegrale entspricht.

**14.** Verfahren nach einem der vorhergehenden Ansprüche, wobei das Verfahren ein Schätzen der Fehlerstrom-Expo-

nentialkomponenten-Zeitkonstante ($\tau$) mittels einer abgeschnittenen Taylorreihen-Näherung der Exponentialkomponente und ein Vorhersagen zukünftiger Werte des Fehlerstroms basierend auf der geschätzten Zeitkonstante umfasst.

15. Computerprogramm, das direkt in den internen Speicher eines Computers ladbar ist und Software zum Ausführen der Schritte nach einem der Ansprüche 1 bis 14 umfasst.

16. Computerlesbares Medium mit einem darauf aufgezeichneten Programm, wobei das Programm einen Computer dazu veranlassen soll, die Schritte nach einem der Ansprüche 1 bis 14 auszuführen, wenn das Programm auf dem Computer ausgeführt wird.

17. Vorrichtung zum Vorhersagen eines zukünftigen Verhaltens eines asymmetrischen Fehlerstroms in einem Stromweg (2), wobei die Vorrichtung Folgendes umfasst:

- ein Element (1), das dazu ausgelegt ist, die Stromstärke in dem Stromweg kontinuierlich abzutasten, und
- eine Vorhersageanordnung (4), die dazu ausgelegt ist, zukünftige Werte der Stromstärke basierend auf den abgetasteten Stromstärkewerten und einem mathematischen Modell der Stromstärke vorherzusagen,

**dadurch gekennzeichnet, dass** die Vorrichtung ferner Folgendes umfasst:

- einen Fehlerstromdetektor (5), der dazu ausgelegt ist, die vorhergesagten Stromstärkewerte mit abgetasteten Stromstärkewerten von demselben Zeitpunkt zu vergleichen und basierend darauf zu bestimmen, ob ein Fehlerstrom in dem Stromweg aufgetreten ist oder nicht, und

dass das Element (1) dazu ausgelegt ist, die abgetasteten Werte der Stromstärke in einem adaptiv bemessenen, sich bewegenden Abtastfenster zu speichern und dann, wenn ein Fehlerstrom detektiert wird, das Abtastfenster anzupassen, um die Stromstärkewerte vor dem Fehlerstrom zu verwerfen, und die Vorhersageanordnung (4) dazu ausgelegt ist, zukünftige Werte des Fehlerstroms basierend auf den Stromstärkewerten in dem angepassten Abtastfenster vorherzusagen.

18. Vorrichtung nach Anspruch 17, **dadurch gekennzeichnet, dass** die Vorhersageanordnung (4) dazu ausgelegt ist, einen oder mehrere charakteristische Parameter für die Stromstärke basierend auf den Daten in dem Abtastfenster zu schätzen, den Spannungsphasenwinkel ($\alpha$) zu dem Zeitpunkt, zu dem der Fehlerstrom begann, zu schätzen und die zukünftigen Werte des Fehlerstroms basierend auf den geschätzten charakteristischen Parametern und dem Spannungsphasenwinkel vorherzusagen.

19. Vorrichtung nach Anspruch 17 oder 18, **dadurch gekennzeichnet, dass** die Vorrichtung ferner Folgendes umfasst:

- ein zweites Element (2), das dazu ausgelegt ist, die Spannung in dem Stromweg kontinuierlich abzutasten und die abgetasteten Werte der Spannung in einem zweiten, sich bewegenden Abtastfenster zu speichern, und
- dass die Prädiktoranordnung (4) dann, wenn bestimmt wird, dass ein Fehlerstrom aufgetreten ist, zu Folgendem ausgelegt ist: Bestimmen des Zeitpunkts, zu dem der Fehlerstrom begann, Schätzen des Spannungsphasenwinkels ($\alpha$) zu dem Zeitpunkt, zu dem der Fehlerstrom begann, basierend auf den abgetasteten Werten der Spannung und Vorhersagen der zukünftigen Werte des Fehlerstroms basierend auf dem geschätzten Spannungsphasenwinkel.

20. Vorrichtung nach Anspruch 18 oder 19, **dadurch gekennzeichnet, dass** die Vorhersageanordnung (4) dazu ausgelegt ist, zukünftige Werte der Stromstärke, bevor ein Fehlerstrom aufgetreten ist, basierend auf einem angenommenen Wert des Spannungsphasenwinkels vorherzusagen.

21. Vorrichtung nach einem der Ansprüche 17-20, **dadurch gekennzeichnet, dass** der Fehlerstromdetektor (5) dazu ausgelegt ist, basierend auf dem Vergleich der vorhergesagten und abgetasteten Stromstärkewerte kontinuierlich zu entscheiden, ob die vorhergesagte Stromstärke ausreichend genau ist oder nicht, und dann, wenn die vorhergesagte Stromstärke nicht ausreichend genau ist, der Fehlerstromdetektor dazu ausgelegt ist, zu bestimmen, ob es einen bleibenden negativen Trend in der Genauigkeit der Vorhersage gibt, und basierend darauf zu entscheiden, ob ein Fehlerstrom aufgetreten ist oder nicht, und das erste erwähnte Element dazu ausgelegt ist, dann, wenn ein Fehlerstrom aufgetreten ist, das Abtastfensters anzupassen, um die Stromstärkewerte vor dem negativen Trend zu verwerfen.

22. Vorrichtung nach Anspruch 19 und 21, **dadurch gekennzeichnet, dass** der Fehlerstromdetektor (5) dazu ausgelegt ist, den Zeitpunkt, zu dem der Fehlerstrom begann, durch Bestimmen des Zeitpunkts, zu dem der negative Trend begann, zu bestimmen und den Spannungsphasenwinkel ($\alpha$) zu dem Zeitpunkt, zu dem der negative Trend begann, zu schätzen.

23. Vorrichtung nach einem der Ansprüche 17-22, **dadurch gekennzeichnet, *dass*** der Fehlerstromdetektor (5) dazu ausgelegt ist, zu bestimmen, ob die Differenz zwischen den vorhergesagten und den gemessenen Stromstärkewerten über eine vorbestimmte Anzahl von aufeinanderfolgenden Abtastwerten ansteigt, und basierend darauf zu bestimmen, ob ein Fehlerstrom aufgetreten ist oder nicht.

24. Vorrichtung nach einem der Ansprüche 17-22, **dadurch gekennzeichnet, dass** sie ferner Folgendes umfasst:

    - eine Nulldurchgangsschätzvorrichtung (6), die dazu ausgelegt ist, zukünftige Nulldurchgänge des Fehlerstroms basierend auf den vorhergesagten zukünftigen Werten der Stromstärke zu schätzen, und
    - eine Steuervorrichtung (7), die dazu ausgelegt ist, den Einsatz einer Unterbrechungsvorrichtung, die in dem Stromweg (2) angeordnet ist und zum Unterbrechen des Stroms in dem Stromweg auf Befehl ausgelegt ist, basierend auf den geschätzten Nulldurchgängen zu steuern, um die Stromunterbrechung zu optimieren.

25. Vorrichtung nach Anspruch 24, **dadurch gekennzeichnet, dass** die Unterbrechungsvorrichtung (8) eine lichtbogenbasierte Unterbrechungsvorrichtung ist, die dazu ausgelegt ist, sich auf Befehl zu öffnen, und die Steuervorrichtung dazu ausgelegt ist, das Öffnen der Unterbrechungsvorrichtung in Bezug auf die geschätzten zukünftigen Nulldurchgänge der Stromstärke zu synchronisieren, um eine gewünschte Lichtbogenzeit zu erreichen.

26. Vorrichtung nach Anspruch 25, **dadurch gekennzeichnet, dass** die Unterbrechungsvorrichtung (8) eine gewisse Öffnungszeit aufweist und die Steuervorrichtung (7) dazu ausgelegt ist, den Öffnungsbefehl an die Unterbrechungsvorrichtung in Bezug auf die Summe der Öffnungszeit der Unterbrechungsvorrichtung und einer gewünschten Lichtbogenzeit zu verzögern.

27. Vorrichtung nach Anspruch 26, **dadurch gekennzeichnet, dass** die Steuervorrichtung (7) dazu ausgelegt ist, eine Zeitspanne für die Verzögerung basierend auf der Differenz zwischen einem ausgewählten geschätzten Stromnulldurchgang und der Summe der gewünschten Lichtbogenzeit und der Öffnungszeit des Unterbrechungsvorrichtung zu berechnen und wiederholt eine neue Zeitspanne für die Verzögerung des Öffnungsbefehls zu berechnen.

28. Vorrichtung nach Anspruch 27, **dadurch gekennzeichnet, dass** die Steuervorrichtung (7) dazu ausgelegt ist, anhand des Vergleichs vorhergesagter und abgetasteter Werte des Stroms ab demselben Zeitpunkt ununterbrochen zu entscheiden, ob der vorhergesagte Strom ausreichend genau ist oder nicht, und, falls der vorhergesagte Strom nicht ausreichend genau ist, die Zeitspanne für die Verzögerung des Öffnungsbefehls auf null gesetzt wird.

29. Vorrichtung nach Anspruch 28, **dadurch gekennzeichnet, dass** die Steuervorrichtung (7) dazu ausgelegt ist, eine Zeitkonstante ($\tau$) für den Fehlerstrom basierend auf den abgetasteten Werten der Stromstärke zu berechnen, den Betrag des Fehlerstroms für mindestens die beiden frühesten geschätzten Stromnulldurchgänge, die für eine Unterbrechung brauchbar sind, zu berechnen, ein Lichtbogenstromintegral für jeden der beiden frühesten geschätzten Stromnulldurchgänge basierend auf dem mathematischen Modell der Stromstärke, der berechneten Zeitkonstante und dem berechneten Betrag des Fehlerstroms zu berechnen, wobei die obere Zeitgrenze der geschätzte Stromnulldurchgang ist und die untere Zeitgrenze die obere Zeitgrenze minus der gewünschten Lichtbogenzeit ist, die berechneten Lichtbogenstromintegrale zu vergleichen, und die Zeitspanne für die Verzögerung des Öffnungsbefehls basierend auf dem Stromnulldurchgang, der dem geringsten der berechneten Lichtbogenstromintegrale entspricht, zu berechnen.

30. Vorrichtung nach einem der Ansprüche 17-29, **dadurch gekennzeichnet, dass** die Vorhersageanordnung (4) dazu ausgelegt ist, die Fehlerstrom-Exponentialkomponenten-Zeitkonstante ($\tau$) mittels einer abgeschnittenen Taylorreihen-Näherung der Exponentialkomponente zu schätzen und zukünftige Werte des Fehlerstroms basierend auf der geschätzten Zeitkonstante vorherzusagen.

31. Verwendung einer Vorrichtung nach einem der Ansprüche 17 - 30 zum Vorhersagen eines zukünftigen Verhaltens eines asymmetrischen Fehlerstroms in einem Stromweg zur Stromversorgung innerhalb der Industrie oder in der Verteilung oder in der Übertragung oder in elektrischen Schienennetzen.

**32.** Verwendung einer Vorrichtung nach einem der Ansprüche 17 bis 30 zum Vorhersagen eines zukünftigen Verhaltens eines asymmetrischen Fehlerstroms in einem Stromweg mit einer Spannung von 1 bis 800 kV.

**33.** Verwendung einer Vorrichtung nach einem der Ansprüche 17 bis 30 zum Bestimmen zukünftiger Stromnulldurchgänge zum Zweck eines Steuerns der Öffnungszeit einer Unterbrechungsvorrichtung.

**34.** Verwendung einer Vorrichtung nach einem der Ansprüche 17 bis 30 zum Bestimmen zukünftiger Stromnulldurchgänge zum Zweck eines Steuerns der Lichtbogenzeit einer lichtbogenbasierten Unterbrechungsvorrichtung.

**35.** Verwendung einer Vorrichtung nach einem der Ansprüche 17 bis 30 zum Bestimmen zukünftiger Stromnulldurchgänge zum Zweck eines Steuerns der Kommutierungszeit einer Unterbrechungsvorrichtung.

**Revendications**

**1.** Procédé de prédiction du futur comportement d'un courant de défaut asymétrique dans un circuit de courant, le procédé comprenant les étapes suivantes :

- échantillonner en continu le courant (i(t)) dans le circuit de courant,
- prédire de futures valeurs du courant sur la base des valeurs de courant échantillonnées et d'un modèle mathématique du courant, **caractérisé en ce que** le procédé comprend en outre les étapes suivantes :
- sauvegarder les valeurs échantillonnées du courant dans une fenêtre d'échantillonnage mobile dimensionnée de façon adaptative,
- comparer les valeurs prédites du courant avec des valeurs échantillonnées du courant provenant du même point dans le temps, et sur cette base
- déterminer si un courant de défaut est apparu ou non dans le circuit de courant, et lors de la détection de l'apparition d'un courant de défaut :

  ∘ ajuster la fenêtre d'échantillonnage mobile pour écarter les valeurs de courant avant le courant de défaut, et
  ∘ prédire de futures valeurs du courant de défaut sur la base des valeurs de courant dans la fenêtre d'échantillonnage ajustée et du modèle mathématique du courant.

**2.** Procédé selon la revendication 1, dans lequel la prédiction du courant comprend les étapes suivantes :

- estimer un ou plusieurs paramètres caractéristiques pour le courant sur la base des données dans la fenêtre d'échantillonnage,
- estimer l'angle de phase de la tension ($\alpha$) au point dans le temps où le courant de défaut a commencé, et
- prédire de futures valeurs du courant de défaut sur la base desdits paramètres caractéristiques estimés et dudit angle de phase de la tension.

**3.** Procédé selon la revendication 1 ou 2, le procédé comprenant en outre les étapes suivantes :

- échantillonner en continu la tension dans le circuit de courant et sauvegarder des valeurs échantillonnées de la tension dans une deuxième fenêtre d'échantillonnage mobile, et s'il a été déterminé qu'un courant de défaut est apparu :

  ∘ déterminer le point dans le temps où le courant de défaut a commencé,
  ∘ estimer l'angle de phase de la tension ($\alpha$) au point dans le temps où le courant de défaut a commencé sur la base desdites valeurs échantillonnées de la tension, et
  ∘ prédire lesdites futures valeurs du courant sur la base dudit angle de phase de la tension estimé.

**4.** Procédé selon la revendication 2 ou 3, dans lequel la prédiction de futures valeurs du courant avant qu'un courant de défaut apparaisse est basée sur une valeur supposée de l'angle de phase de la tension ($\alpha$).

**5.** Procédé selon l'une quelconque des revendications précédentes, le procédé comprenant en outre les étapes suivantes :

- décider en continu si le courant prédit est suffisamment précis sur la base de ladite comparaison des valeurs de courant prédites et échantillonnées, et si le courant prédit n'est pas suffisamment précis :
- déterminer s'il existe une tendance négative durable dans la précision de la prédiction et sur cette base décider si un courant de défaut est apparu, et
- ajuster la fenêtre d'échantillonnage pour écarter les valeurs de courant avant la tendance négative.

6. Procédé selon la revendication 3 et 5, le procédé comprenant les étapes consistant à déterminer le point dans le temps où le courant de défaut a commencé en déterminant le point dans le temps où la tendance négative a commencé, et estimer l'angle de phase de la tension ($\alpha$) au point dans le temps où la tendance négative a commencé.

7. Procédé selon l'une quelconque des revendications précédentes, dans lequel ladite détection du moment où un courant de défaut est apparu comprend l'étape suivante : déterminer si la différence entre les valeurs de courant prédites et mesurées augmente sur un nombre prédéterminé d'échantillons successifs, et le cas échéant qu'un courant de défaut est détecté.

8. Procédé selon l'une quelconque des revendications précédentes, le procédé comprenant les étapes consistant à estimer un ou plusieurs futurs passages par zéro (Z1 - Z5) du courant de défaut sur la base des futures valeurs prédites du courant, et sur la base des passages par zéro estimés contrôler l'action d'un dispositif d'interruption agencé dans le circuit de courant pour interrompre le courant sur commande, afin d'optimiser l'interruption de courant.

9. Procédé selon la revendication 8, dans lequel le dispositif d'interruption est un dispositif d'interruption à base d'arc adapté pour s'ouvrir sur commande, et le procédé comprend l'étape consistant à synchroniser l'ouverture du dispositif d'interruption par rapport aux futurs passages par zéro estimés afin d'obtenir un temps de formation d'arc souhaité.

10. Procédé selon la revendication 9, dans lequel ledit dispositif d'interruption a un certain temps d'ouverture ($t_{ouvert}$), et ladite synchronisation comporte le retard de la commande d'ouverture au dispositif d'interruption par rapport à la somme du temps d'ouverture du dispositif d'interruption et d'un temps de formation d'arc souhaité ($t_{arc}$).

11. Procédé selon la revendication 10, le procédé comprenant les étapes consistant à calculer un laps de temps pour le retard ($t_{attente}$) sur la base de la différence entre un passage par zéro du courant estimé sélectionné et la somme du temps de formation d'arc souhaité ($t_{arc}$) et du temps d'ouverture ($t_{ouvert}$) du dispositif d'interruption, et calculer de façon répétée un nouveau laps de temps pour le retard de la commande d'ouverture.

12. Procédé selon la revendication 11, le procédé comprenant les étapes consistant à comparer en continu les valeurs prédites du courant avec des valeurs échantillonnées du courant provenant du même point dans le temps, et sur cette base décider si le courant prédit est suffisamment précis ou non, et si le courant prédit n'est pas suffisamment précis, le laps de temps pour le retard ($t_{attente}$) de la commande d'ouverture est réglé à zéro.

13. Procédé selon la revendication 12, le procédé comprenant les étapes suivantes :

- calculer une constante de temps ($\tau$) pour le courant de défaut sur la base des valeurs échantillonnées du courant,
- calculer l'amplitude du courant de défaut ($i_{arc}$) au moins pour les deux passages par zéro du courant estimés les plus précoces viables pour une interruption,
- calculer une intégrale de courant d'arc pour chacun desdits deux passages par zéro du courant estimés les plus précoces, sur la base du modèle mathématique du courant, de la constante de temps calculée et de l'amplitude calculée du courant de défaut, la limite de temps supérieure étant le passage par zéro du courant estimé et la limite de temps inférieure étant la limite de temps supérieure réduite du temps de formation d'arc souhaité,
- comparer les intégrales de courant d'arc calculées, et
- calculer le laps de temps pour le retard de la commande d'ouverture sur la base du passage par zéro du courant correspondant à la plus petite des intégrales de courant d'arc calculées.

14. Procédé selon l'une quelconque des revendications précédentes, le procédé comprenant les étapes consistant à estimer la constante de temps de la composante exponentielle du courant de défaut ($\tau$) au moyen d'approximations par une série de Taylor tronquée de la composante exponentielle, et prédire de futures valeurs du courant de défaut sur la base de ladite constante de temps estimée.

15. Programme informatique directement chargeable dans la mémoire interne d'un ordinateur, comprenant un logiciel pour effectuer les étapes de l'une quelconque des revendications 1 à 14.

**16.** Support lisible par ordinateur, ayant un programme enregistré sur celui-ci, le programme étant destiné à amener un ordinateur à effectuer les étapes de l'une quelconque des revendications 1 à 14 quand ledit programme est exécuté sur l'ordinateur.

**17.** Appareil de prédiction du futur comportement d'un courant de défaut asymétrique dans un circuit de courant (2), l'appareil comprenant :

- un élément (1) adapté pour échantillonner en continu le courant dans le circuit de courant, et
- un agencement de prédiction (4) adapté pour prédire de futures valeurs du courant dans le circuit de courant sur la base des valeurs de courant échantillonnées et d'un modèle mathématique du courant,

**caractérisé en ce que** l'appareil comprend en outre :

- un détecteur de courant de défaut (5) adapté pour comparer les valeurs de courant prédites avec des valeurs de courant échantillonnées provenant du même point dans le temps, et sur cette base déterminer si un courant de défaut est apparu ou non dans le circuit de courant, et

ledit élément (1) est adapté pour sauvegarder les valeurs échantillonnées du courant dans une fenêtre d'échantillonnage mobile dimensionnée de façon adaptative et lors de la détection d'un courant de défaut, ajuster la fenêtre d'échantillonnage pour écarter les valeurs de courant avant le courant de défaut, et ledit agencement de prédiction (4) est adapté pour prédire de futures valeurs du courant de défaut sur la base des valeurs de courant dans la fenêtre d'échantillonnage ajustée.

**18.** Appareil selon la revendication 17, **caractérisé en ce que** ledit agencement de prédiction (4) est adapté pour estimer un ou plusieurs paramètres caractéristiques pour le courant sur la base des données dans la fenêtre d'échantillonnage, pour estimer l'angle de phase de la tension ($\alpha$) au point dans le temps où le courant de défaut a commencé, et pour prédire les futures valeurs du courant de défaut sur la base desdits paramètres caractéristiques estimés et dudit angle de phase de la tension.

**19.** Appareil selon la revendication 17 ou 18, **caractérisé en ce que** l'appareil comprend en outre :

- un deuxième élément (2) adapté pour échantillonner en continu la tension dans le circuit de courant et pour sauvegarder des valeurs échantillonnées de la tension dans une deuxième fenêtre d'échantillonnage mobile, et
- **en ce que** ledit agencement de prédiction (4) est adapté pour, lorsqu'il est déterminé qu'un courant de défaut est apparu, déterminer le point dans le temps où le courant de défaut a commencé, estimer l'angle de phase de la tension au point dans le temps où le courant de défaut a commencé sur la base desdites valeurs échantillonnées de la tension, et prédire ainsi lesdites futures valeurs du courant sur la base dudit angle de phase de la tension estimé.

**20.** Appareil selon la revendication 18 ou 19, **caractérisé en ce que** ledit agencement de prédiction (4) est adapté pour prédire les futures valeurs du courant, avant qu'un courant de défaut apparaisse, sur la base d'une valeur supposée de l'angle de phase de la tension.

**21.** Appareil selon l'une quelconque des revendications 17 à 20, **caractérisé en ce que** ledit détecteur de courant de défaut (5) est adapté pour décider en continu si le courant prédit est suffisamment précis ou non, sur la base de ladite comparaison des valeurs prédites et échantillonnées, et si le courant prédit n'est pas suffisamment précis le détecteur de courant de défaut est adapté pour déterminer s'il existe une tendance négative durable dans la précision de la prédiction, et sur cette base décider si un courant de défaut est apparu ou non, et ledit premier élément mentionné est adapté pour, lors de la détection d'un courant de défaut, ajuster la fenêtre d'échantillonnage pour écarter les valeurs de courant avant la tendance négative.

**22.** Appareil selon la revendication 19 et 21, **caractérisé en ce que** ledit détecteur de courant de défaut (5) est adapté pour déterminer le point dans le temps où le courant de défaut a commencé en déterminant le point dans le temps où la tendance négative a commencé, et pour estimer l'angle de phase de la tension ($\alpha$) au point dans le temps où la tendance négative a commencé.

**23.** Appareil selon l'une quelconque des revendications 17 à 22, **caractérisé en ce que** ledit détecteur de courant de défaut (5) est adapté pour déterminer si la différence entre les valeurs d courant prédites et mesurées augmente

EP 1 854 113 B1

sur un nombre prédéterminé d'échantillons successifs, et sur cette base déterminer si un courant de défaut est apparu ou non.

24. Appareil selon l'une quelconque des revendications 17 à 23, **caractérisé en ce qu'**il comprend

- un estimateur de passage par zéro (6) adapté pour estimer de futurs passages par zéro du courant de défaut sur la base des futures valeurs prédites du courant, et
- un dispositif de contrôle (7) adapté pour contrôler l'action d'un dispositif d'interruption (8), agencé dans le circuit de courant (2) et adapté pour interrompre sur commande le courant dans le circuit de courant, sur la base des passages par zéro du courant estimés, afin d'optimiser l'interruption de courant.

25. Appareil selon la revendication 24, **caractérisé en ce que** le dispositif d'interruption (8) est un dispositif d'interruption à base d'arc adapté pour s'ouvrir sur commande, et le dispositif de contrôle est adapté pour synchroniser l'ouverture du dispositif d'interruption par rapport aux futurs passages par zéro estimés du courant afin d'obtenir un temps de formation d'arc souhaité.

26. Appareil selon la revendication 25, **caractérisé en ce que** ledit dispositif d'interruption (8) a un certain temps d'ouverture, et ledit dispositif de contrôle (7) est adapté pour retarder la commande d'ouverture au dispositif d'interruption par rapport à la somme d'un temps d'ouverture du dispositif d'interruption et d'un temps de formation d'arc souhaité.

27. Appareil selon la revendication 26, **caractérisé en ce que** ledit dispositif de contrôle (7) est adapté pour calculer un laps de temps pour le retard, sur la base de la différence entre un passage par zéro du courant estimé sélectionné et la somme du temps de formation d'arc souhaité et du temps d'ouverture du dispositif d'interruption, et pour calculer de façon répétée un nouveau laps de temps pour le retard de la commande d'ouverture.

28. Appareil selon la revendication 27, **caractérisé en ce que** ledit dispositif de contrôle (7) est adapté pour décider en continu si le courant prédit est suffisamment précis ou non sur la base de ladite comparaison de valeurs prédites et échantillonnées du courant issues du même point dans le temps, et si le courant prédit n'est pas suffisamment précis, le laps de temps pour le retard de la commande d'ouverture est réglé à zéro.

29. Appareil selon la revendication 28, **caractérisé en ce que** ledit dispositif de contrôle (7) est adapté pour calculer une constante de temps ($\tau$) pour le courant de défaut sur la base des valeurs échantillonnées du courant, pour calculer l'amplitude du courant de défaut au moins pour les deux passages par zéro du courant estimés les plus précoces viables pour une interruption, pour calculer une intégrale de courant d'arc pour chacun desdits deux passages par zéro du courant estimés les plus précoces, sur la base du modèle mathématique du courant, de la constante de temps calculée et de l'amplitude calculée du courant de défaut, la limite de temps supérieure étant le passage par zéro du courant estimé et la limite de temps inférieure étant la limite de temps supérieure réduite du temps de formation d'arc souhaité, pour comparer les intégrales de courant d'arc calculées, et pour calculer le laps de temps pour le retard de la commande d'ouverture sur la base du passage par zéro du courant correspondant à la plus petite des intégrales de courant d'arc calculées.

30. Appareil selon l'une quelconque des revendications 17 à 29, **caractérisé en ce que** ledit agencement de prédiction (4) est adapté pour estimer la constante de temps de la composante exponentielle du courant de défaut ($\tau$) au moyen d'approximations par une série de Taylor tronquée de la composante exponentielle, et pour prédire de futures valeurs du courant de défaut sur la base de ladite constante de temps estimée.

31. Utilisation d'un appareil selon l'une quelconque des revendications 17 à 30 pour prédire le futur comportement d'un courant de défaut asymétrique dans un circuit de courant pour la fourniture d'électricité dans l'industrie ou dans la distribution ou dans la transmission ou dans les réseaux ferroviaires électriques.

32. Utilisation d'un appareil selon l'une quelconque des revendications 17 à 30 pour prédire le futur comportement d'un courant de défaut asymétrique dans un circuit de courant ayant une tension entre 1 et 800 kV.

33. Utilisation d'un appareil selon l'une quelconque des revendications 17 à 30 pour déterminer de futurs passages par zéro du courant dans le but de contrôler le temps d'ouverture d'un dispositif d'interruption.

34. Utilisation d'un appareil selon l'une quelconque des revendications 17 à 30 pour déterminer de futurs passages par

25

zéro du courant dans le but de contrôler le temps de formation d'arc d'un dispositif d'interruption à base d'arc.

35. Utilisation d'un appareil selon l'une quelconque des revendications 17 à 30 pour déterminer de futurs passages par zéro du courant dans le but de contrôler le temps de commutation d'un dispositif d'interruption.

Fig. 1

27

Fig. 2

Fig. 3

Fig. 4

Fig. 5

Fig. 6

EP 1 854 113 B1

Fig. 7

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0195354 A

- US 6597999 B

### Non-patent literature cited in the description

- **ANTON PÖLTL ; KLAUS FRÖHLICH.** A new algorithm enabling controlled short circuit interruption. *IEEE Transactions on power delivery,* July 2003, vol. 18 (3

- **STRANG G.** Linear Algebra and its Applications. Brooks/Cole Thomson Learning Inc, 1988
- **MONTGOMERY DOUGLAS C. ; RUNGER GEORGE C.** Applied Statistics and Probability for Engineers. John Wiley & Sons, Inc, 1999